# EUROPEAN PATENT SPECIFICATION

(11) **EP 3 282 475 B1**
(45) Date of publication and mention of the grant of the patent: **08.09.2021**
(21) Application number: 16776316.8
(22) Date of filing: 10.02.2016
(51) Int. Cl.: H01L 21/683

(54) **SUBSTRATE HOLDING METHOD, SUBSTRATE HOLDING DEVICE, PROCESSING METHOD AND PROCESSING DEVICE**
SUBSTRATHALTEVERFAHREN, SUBSTRATHALTEVORRICHTUNG, VERARBEITUNGSVERFAHREN UND VERARBEITUNGSVORRICHTUNG
PROCÉDÉ DE MAINTIEN DE SUBSTRAT, DISPOSITIF DE MAINTIEN DE SUBSTRAT, PROCÉDÉ DE TRAITEMENT ET DISPOSITIF DE TRAITEMENT

(30) Priority: 04.04.2015 JP 2015077278; 25.11.2015 JP 2015229657
(43) Date of publication of application: 14.02.2018
(73) Proprietor: Tokyo Electron Limited, Tokyo 107-6325 (JP)
(72) Inventor: OBIKANE Tadashi, Nirasaki city Yamanashi 407-8511 (JP); SHIBATA Hidekazu, Nirasaki city Yamanashi 407-8511 (JP)
(74) Representative: Hoffmann Eitle
(86) International application number: PCT/JP2016/053953
(87) International publication number: WO 2016/163147

(56) References cited:
- WO-A1-2015/046243
- JP-A- 2000 124 298
- JP-A- 2010 129 706
- JP-A- 2012 201 437
- JP-A- 2013 120 902
- JP-A- 2013 232 630
- JP-A- 2014 195 016
- US-A1- 2013 025 114
- US-A1- 2014 014 471

## Description

### Field of the Invention

The present invention relates to a substrate holding method for attracting and holding a circular substrate on a stage, to a corresponding substrate holding apparatus and to a processing apparatus comprising the substrate holding apparatus.

### Background of the Invention

In a semiconductor device manufacturing process, probe inspection is performed to evaluate electrical characteristics of semiconductor devices. In the probe inspection, the electrical characteristics are evaluated by bringing probe needles into contact with electrodes of semiconductor devices formed on a semiconductor substrate, inputting electrical signals into the respective semiconductor devices and monitoring electrical signals outputted therefrom.

A probe apparatus used for the probe inspection includes: a horizontally and vertically movable and rotatable stage (mounting table) for holding an inspection target substrate on which semiconductor devices are formed; and an alignment device for bringing probe needles into contact with electrodes of the semiconductor devices formed on the inspection target substrate with high accuracy. In order to increase reliability of the probe inspection, it is important to hold the inspection target substrate on the stage without misalignment.

As for a technique for holding a substrate in a semiconductor processing field, there is known a vacuum check for fixing a backside of a substrate to a stage by decreasing a pressure in a gap therebetween.

For example, Japanese Patent Application Publication No. 2013-214676 (Patent Document 1) suggests a technique that can separately control a suction pressure in a central region and an outer peripheral region of a porous holding part in order to horizontally hold a warped substrate.

In addition, as for a technique related to a substrate transfer device, there is suggested in Japanese Patent Application Publication No. 2000-243814 (Patent Document 2), a technique capable of reliably sucking a warped substrate by ejecting gas from above a substrate holding device having a vacuum suction hole.

In the case of attracting and holding a circular substrate, the substrate can be sucked by forming a plurality of grooves concentrically in a substrate holding surface of a stage and decreasing a pressure in the grooves. However, a mechanism for decreasing a pressure in the concentrically arranged grooves is disadvantageous in that sufficient attraction force is not obtained when leakage occurs at one position on the circumference of the substrate due to warpage of the substrate. Especially, due to a recent trend toward scaling up of a substrate and decrease in a thickness of the substrate, the substrate is easily warped. It is also required to deal with a substrate, e.g., a resin substrate, a glass substrate or the like, which is easily warped compared to a semiconductor wafer.

WO 2015/046243 A1 discloses features falling under the preamble of claim 1.

### Summary of the Invention

In view of the above, the present invention provides a substrate holding method and a substrate holding device which can reliably attract and hold a substrate that is likely to warp considerably.

The invention is defined by the independent claims.

A substrate holding method of the present invention is a method for attracting and holding a substrate on a stage. In the substrate holding method of the present invention, the stage has a substrate holding surface on which a bottom surface of the substrate is attracted and held, and the substrate holding surface is divided into a plurality of regions by which the substrate is partially sucked. Further, in the substrate holding method of the present invention, an entire surface of the substrate is attracted and held on the stage by sequentially repeating a process of allowing a part of the substrate to be sucked by at least one of the plurality of regions and then allowing another part of the substrate to be sucked by a region adjacent to said at least one of the plurality of regions. In addition, when the substrate is partially sucked, a sucked portion of the substrate is pressed against the substrate holding surface by a pressing unit.

In the substrate holding method of the present invention, the pressing unit may be a gas ejection unit for ejecting a gas toward a top surface of the sucked portion. In this case, the gas may be a heating gas and a temperature of the heating gas may be maintained within a range of ±10°C with respect to a temperature of the stage.

In the substrate holding method of the present invention, the pressing unit may have a pressing member configured to press a top surface of the sucked portion against the substrate holding surface while being in contact with the top surface of the sucked portion.

In the substrate holding method of the present invention, the substrate has a circular shape and the substrate holding surface has a circular shape, and the plurality of regions may include a central region corresponding to a central portion of the substrate and a plurality of peripheral regions surrounding the central region. Further, the substrate holding method of the present invention may sequentially perform the steps of:
allowing the central portion of the substrate to be sucked by the central region;
allowing a part of the peripheral portion of the substrate to be sucked by one of the plurality ofperipheral regions;
allowing another part of the peripheral portion of the substrate to be sucked by one or two peripheral regions adjacent to said one of the plurality of peripheral regions; and
allowing still another part of the peripheral portion of the substrate to be sucked by a peripheral region adjacent to said one or two peripheral regions.

In the substrate holding method of the present invention, the substrate has a circular shape and the substrate holding surface has a circular shape, and the plurality of regions may include a central region corresponding to a central portion of the substrate and a plurality of peripheral regions surrounding the central region. Further, the substrate holding method of the present invention may sequentially perform the steps of:
allowing the central portion of the substrate to be sucked by the central region;
allowing the peripheral portion of the substrate to be partially sucked by two of the plurality of peripheral regions;
allowing another part of the peripheral portion of the substrate to be sucked by two or more peripheral regions adjacent to said two of the plurality of peripheral regions; and
allowing still another part of the peripheral portion of the substrate to be sucked by at least two peripheral regions adjacent to said two or more peripheral regions.

In the substrate holding method of the present invention, the plurality of peripheral regions may include two or more peripheral regions having different areas, and the peripheral portion of the substrate may be partially and sequentially sucked by the plurality of peripheral regions from a smallest area to a largest area.

In the substrate holding method of the present invention, in a state where the substrate is sucked, leakage detection for detecting intrusion of external air may be performed for all or each of the plurality of regions or for each group of two or more regions.

A processing method of the present invention is a method for performing predetermined processing on a substrate, and includes a step of attracting and holding a substrate on a stage by using the substrate holding method described above.

The processing method of the present invention may be a device inspecting method for inspecting electrical characteristics of a plurality of devices formed on the substrate.

A substrate holding apparatus of the present invention includes: a stage configured to attract and hold a substrate; and a pressing unit configured to press a part of the substrate against a substrate holding surface. The stage has the substrate holding surface on which a bottom surface of the substrate is attracted and held and the substrate holding surface is divided into a plurality of regions by which the substrate is partially sucked. Further, in the substrate holding apparatus of the present invention, the pressing unit presses a sucked portion that is a part of the substrate which is sucked by any of the plurality of regions of the stage.

In the substrate holding apparatus of the present invention, the pressing unit may be a gas ejection unit configured to eject a gas toward a top surface of the sucked portion. In this case, the gas ejection unit may have a nozzle for ejecting the gas for all or each of the plurality of regions of the stage or for each group of two or more regions. In this case, the gas may bea heating gas and a temperature of the heating gas may be maintained within a range of ±10°C with respect to a temperature of the stage.

In the substrate holding apparatus of the present invention, the pressing unit may have a pressing member configured to press a top surface of the sucked portion against the substrate holding surface while being in contact with the top surface of the sucked portion. In this case, a portion of the pressing member which is brought into contact with the substrate may be made of ceramic, synthetic resin or rubber.

The substrate holding apparatus of the present invention may further include a leakage detection unit configured to detect intrusion of external air in a state where the substrate is sucked for all or each of the plurality of regions or for each group of two or more regions.

In the substrate holding apparatus of the present invention, the substrate may have a circular shape and the substrate holding surface has a circular shape, the plurality of regions may include a central region corresponding to a central portion of the substrate and a plurality of peripheral regions surrounding the central region and corresponding to a peripheral portion of the substrate, and the plurality of peripheral regions may include two or more peripheral regions having different areas.

In the substrate holding apparatus of the present invention, the central region may include a plurality of regions divided in a diametrical direction of the substrate holding surface and the plurality of peripheral regions may include a plurality of regions divided in a diametrical direction of the substrate holding surface.

A processing apparatus of the present invention is an apparatus for performing a predetermined processing on a substrate, and includes the substrate holding apparatus described above.

The processing apparatus of the present invention may be a probe apparatus for inspecting electrical characteristics of a plurality of devices formed on the substrate.

### Brief Description of the Drawings

Fig. 1 is a perspective view showing an external configuration of a probe apparatus according to a first example.
Fig. 2 is a perspective view schematically showing an inner structure of the probe apparatus shown in Fig. 1.
Fig. 3 is a top view of a holding surface of a stage.
Fig. 4 is a vertical cross sectional view showing principal parts which is taken along line IV-IV in Fig. 3.
Fig. 5 is an enlarged view of A part surrounded by a dashed line in Fig. 4.
Fig. 6 explains a connection state between a vacuum pump and a plurality of suction regions in a vacuum chuck mechanism.
Fig. 7 schematically explains positional relation between a gas ejection device and a substrate held on the stage.
Fig. 8 schematically explains another configuration example of the gas ejection device.
Fig. 9 explains an example of a hardware configuration of a control unit.
Fig. 10 explains relation between portions of a substrate and suction regions on the holding surface of the stage.
Fig. 11 is a flowchart for explaining an exemplary sequence of a substrate holding method according to an example.
Fig. 12 is a flowchart for explaining another exemplary sequence of the substrate holding method according to the example.
Fig. 13 is a flowchart for explaining still another exemplary sequence of the substrate holding method according to the example.
Fig. 14 is a top view of a holding surface of a stage, which is used for explaining a first modification.
Fig. 15 is a top view of a holding surface of a stage, which is used for explaining a second modification.
Fig. 16 is a top view of a holding surface of a stage, which is used for explaining a third modification.
Fig. 17 is a perspective view schematically showing an inner structure of a probe apparatus according to a second embodiment.
Fig. 18 explains a pressing device.
Fig. 19 explains another state of the pressing device.
Fig. 20 explains a plurality of suction regions formed on a holding surface of a stage,
Figs. 21 to 33 views for explaining a substrate holding sequence in the probe apparatus shown in Fig. 17.

### Detailed Description of the Examples and Embodiments

Hereinafter, examples will be described with reference to the accompanying drawings.

### (First example)

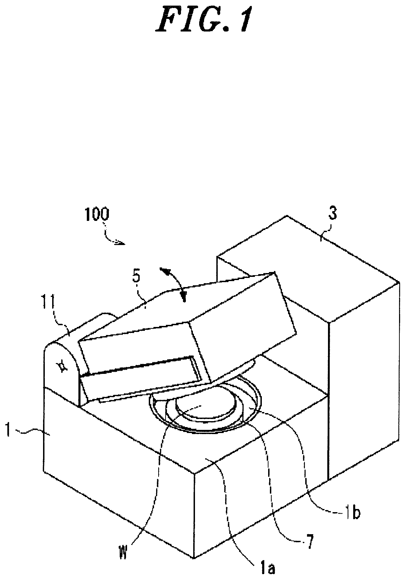

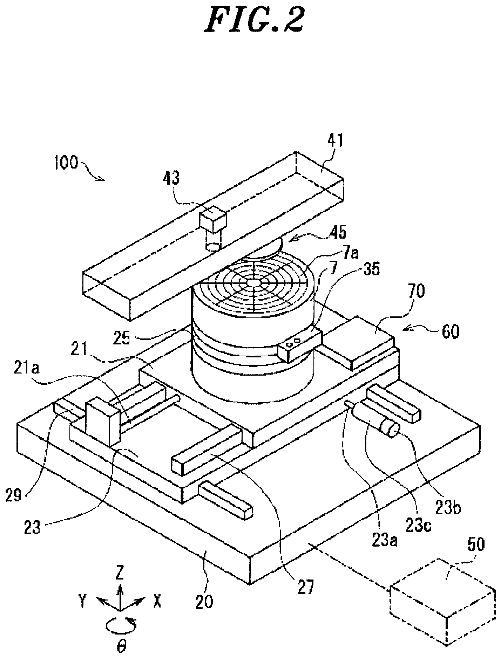

Fig. 1 is a perspective view showing an external configuration of a probe apparatus 100 according to a first example. Fig. 2 is a perspective view schematically showing an inner structure of the probe apparatus 100 shown in Fig. 1.

The probe apparatus 100 of the present example is for inspecting electrical characteristics of devices (not shown) such as semiconductor devices formed on a substrate (hereinafter, simply referred to as "wafer"), e.g., a semiconductor wafer, a resin substrate or the like. The probe apparatus 100 includes: a main body 1; a loader unit 3 provided near the main body 1; a test head 5 provided to cover the main body 1; a stage 7 for mounting thereon a wafer W; and a control unit 50 for controlling the respective components of the probe apparatus 100.

### (Main body)

The main body 1 is a hollow housing in which the stage 7 is accommodated. An opening 1b is formed in a ceiling portion 1a of the main body 1. The opening 1b is provided above the wafer W mounted on the stage 7. A substantially disc-shaped probe card holder (not shown) which holds a disc-shaped probe card (not shown) having a plurality of probe needles is attached to the opening 1b. The probe card is made to face the wafer W mounted on the stage 7 by the probe card holder.

### (Loader unit)

The loader unit 3 unloads the wafer W from a FOUP (not shown) as a transfer container and transfers the wafer W to the stage 7 of the main body 1. Further, the loader unit 3 receives a wafer W that has been subjected to inspection of electrical characteristics of devices from the stage 7 and returns the wafer W to the FOUP.

### (Test head)

The test head 5 has a rectangular parallelepiped shape and is configured to be rotatable upward by a hinge mechanism 11 provided on the main body 1. When the main body 1 is covered by the test head 5, the test head 5 is electrically connected to the probe card via a contact ring (not shown). The test head 5 has a function of storing, as a measurement data, an electrical signal indicating electrical characteristics of a device which is transmitted from the probe card, and determining whether or not the device has electrical defects based on the measurement data.

### (Stage)

As shown in Fig. 2, the stage 7 includes an X direction moving unit 21 movable along the X direction in Fig. 2, a Y direction moving unit 23 movable along the Y direction in Fig. 2 and a Z direction moving unit 25 movable along the Z direction in Fig. 2, which are provided on a base 20. The stage 7 further includes a vacuum chuck mechanism 60 for attracting and holding the wafer W. A top surface of the stage 7 serves as a holding surface 7a on which the wafer W is sucked and held by the vacuum chuck mechanism 60. A detailed configuration of the vacuum chuck mechanism 60 will be described later. A heater (not shown) is provided at the stage 7 and configured to control a temperature of the holding surface 7a within a range of, e.g., 25°C to 200°C.

The X direction moving unit 21 moves the stage 7 with high accuracy in the X direction by rotation of a ball screw 21a along a guide rail 27 extended in the X direction. The ball screw 21a is rotated by a motor (not shown). The moving amount of the stage 7 can be detected by an encoder (not shown) assembled to the motor.

The Y direction moving unit 23 moves the stage 7 with high accuracy in the Y direction by rotation of a ball screw 23a along a guide rail 29 extended in the Y direction. The ball screw 23a is rotated by a motor 23b. The moving amount of the stage 7 can be detected by an encoder 23c assembled to the motor 23b.

In this manner, the X direction moving unit 21 and the Y direction moving unit 23 move the stage 7 in the X direction and the Y direction orthogonal to each other along the horizontal plane.

The Z direction moving unit 25 has a motor and an encoder (both not shown). The Z direction moving unit 25 can move the stage 7 up and down along the Z direction and detect the moving amount thereof. The Z direction moving unit 25 moves the stage 7 toward the probe card and brings the electrodes of the devices on the wafer W into contact with the probe needles. The stage 7 is rotatable on the Z direction moving unit 25 in θ direction in Fig. 2 by a motor (not shown).

### (Lower image pickup unit)

A lower image pickup unit 35 is provided inside the main body 1. Here, the lower image pickup unit 35 captures images of the probe needles formed at the probe card. The lower image pickup unit 35 is fixed to the stage 7 and moves along the X direction, the Y direction and the Z direction together with the stage 7.

### (Alignment unit)

An alignment unit 41 is provided above the stage 7 inside the main body 1. The alignment unit 41 is configured to be movable along the Y direction in Fig. 2 by a driving unit (not shown). The alignment unit 41 has a bottom surface facing the stage 7 or the lower image pickup unit 35.

### (Upper image pickup unit)

The alignment unit 41 is provided with an upper image pickup unit 43. The upper image pickup unit 43 captures images of the electrodes of the devices formed on the wafer W mounted on the stage 7.

### (Gas ejection unit)

The alignment unit 41 is provided with a gas ejection unit 45 for ejecting a gas toward the top surface of the wafer W mounted on the stage 7. The gas ejection unit 45 ejects a gas, e.g., dry air or the like, to the top surface of the wafer W. The gas ejection unit 45 serves as an auxiliary unit for making suction of the wafer W easier in the case of attracting and holding the wafer W on the stage 7 by the vacuum chuck mechanism 60. The stage 7 having the vacuum chuck mechanism 60 and the gas ejection unit 45 constitute a substrate holding device of the present invention and allow the wafer W to be attracted and held on the holding surface 7a. A detailed configuration of the gas ejection unit 45 will be described later.

### (Vacuum chuck mechanism)

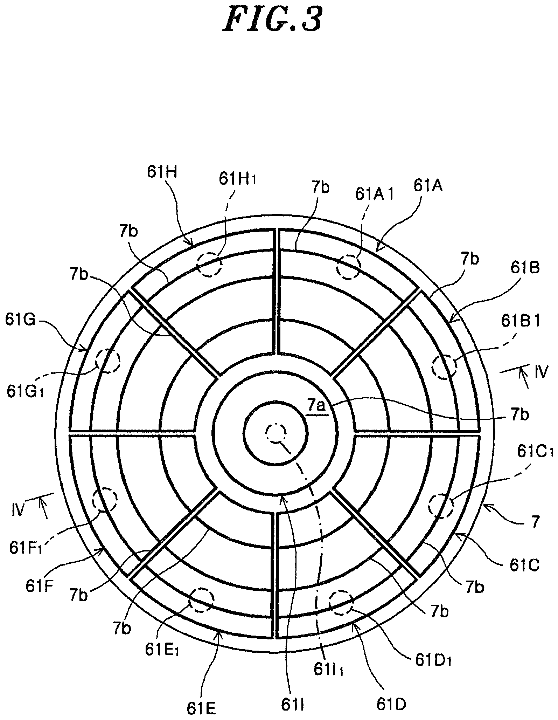

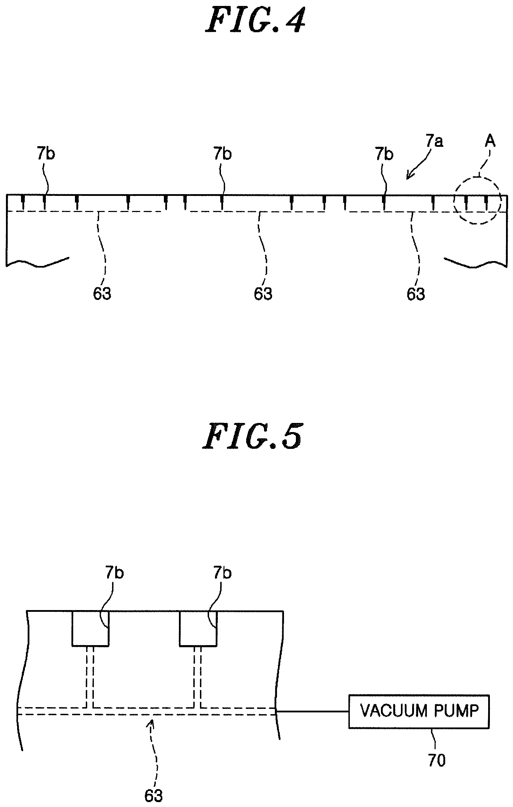

Next, the vacuum chuck mechanism 60 in the stage 7 will be described with reference to Figs. 3 to 6. Fig. 3 is a top view of the holding surface 7a that is the top surface of the stage 7. Fig. 4 is a vertical cross sectional view showing an upper portion of the stage 7 which is taken along line IV-IV in Fig. 3. Fig. 5 is an enlarged view of A part surrounded by a dashed line in Fig. 4. The vacuum chuck mechanism 60 includes suction grooves 7b formed in the holding surface 7a of the stage 7, a suction line 63 connected to the suction grooves 7b, and a vacuum pump 70 connected to the other end of the suction line 63.

The fine suction grooves 7b for sucking the wafer W are formed in the holding surface 7a of the stage 7. In Figs. 3 and 4, the suction grooves 7b are indicated by lines. However, as can be seen from the enlarged view in Fig. 5, the suction grooves 7b are recesses formed in the holding surface 7a of the stage 7. The suction grooves 7b are connected to the vacuum pump 70 through the suction line 63. In a state where the wafer W is held on the holding surface 7a, the suction grooves 7b are sealed by the wafer W and a pressure in the grooves is maintained in a depressurized state.

The suction grooves 7b are divided into a plurality of suction regions 61. In the example shown in Fig. 3, the suction grooves 7b are divided into nine suction regions 61A, 61B, 61C, 61D, 61E, 61F, 61G, 61H and 61I which can be separately maintained in a depressurized state. The suction region 61I is a central region provided at a central portion of the holding surface 7a having a circular shape when seen from the top. The suction regions 61A, 61B, 61C, 61D, 61E, 61F, 61G and 61H are outer peripheral regions provided around the suction region 611 on the holding surface 7a having a circular shape when seen from the top. The suction region 61I sucks the central portion of the circular wafer W. The suction regions 61A, 61B, 61C, 61D, 61E, 61F, 61G and 61H suck the peripheral portion of the circular wafer W.

In the respective suction regions 61A to 61I, the suction grooves 7b are formed in a predetermined pattern. The suction grooves 7b communicate with each other in the respective suction regions 61A to 61I. However, the suction grooves 7b do not communicate with each other between different suction regions.

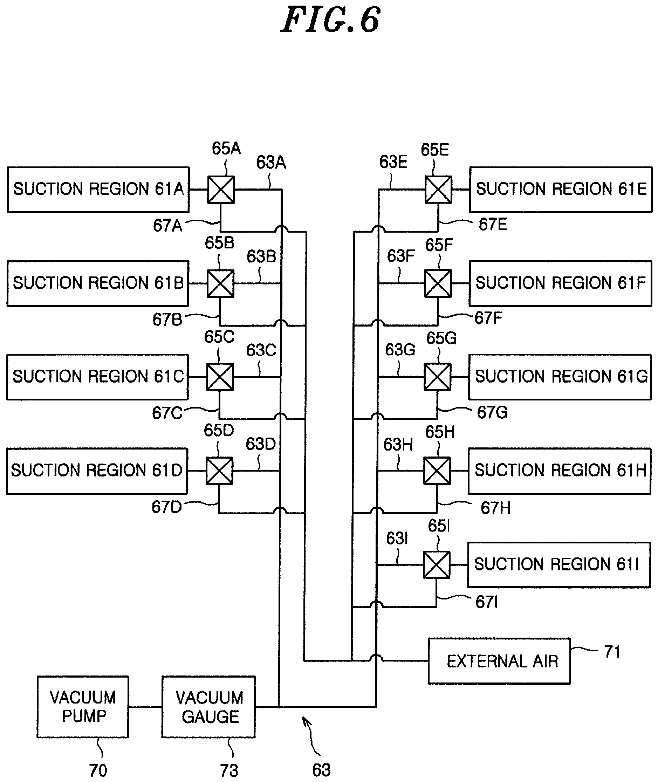

Fig. 6 shows a connection state between the vacuum pump 70 and the suction regions 61A to 611 in the vacuum chuck mechanism 60. The suction grooves 7b in the respective suction regions 61A to 61I are connected to the vacuum pump 70 through lines 63A to 631 each forming a part of the suction line 63. Switching valves 65A to 65I are provided in the respective lines 63A to 63I. The switching valves 65A to 65I perform switching between a state in which the suction regions 61A to 61I can be sucked by the vacuum pump 70 and a state in which the suction regions 61A to 61I are exposed to external air 71 through gas exhaust lines 67A to 671. With the above configuration, each of the suction regions 61A to 61I can suck the wafer W partially. For example, the suction region 61A and the suction region 61B can separately have a suction state and a non-suction state for the wafer W. By controlling the suction state and the non-suction state of the respective suction regions 61A to 611 separately, it is possible to reliably suck an entire surface of a wafer W that is likely to warp considerably, as will be described later. Further, since the suction state and the non-suction state of the respective suction regions 61A to 611 can be controlled separately, even if the wafer W that is likely to warp considerably has portions where the suction is insufficient, it is possible to reliably attract and hold the wafer W at other portions. Accordingly, the misalignment of the wafer W during the probe inspection can be prevented.

A vacuum gauge 73 is provided in the suction line 63. By measuring a pressure in the suction line 63 by the vacuum gauge 73, it is possible to detect whether or not leakage in which external air enters occurs at any one of the suction regions 61A to 611. The vacuum gauge 73 may be provided for each of the suction regions 61A to 61I, not for all the suction regions 61A to 611. Or, the suction regions 61A to 611 may be divided into a plurality of groups and the vacuum gauge 73 may be provided for each group.

In the present example, the holding surface 7a is divided into the nine suction regions 61A to 611. However, the number of the suction regions is not limited to nine. For example, the holding surface 7a may be divided into a plurality of fanwise-shaped suction regions 61 arranged along the circumferential direction without being divided into a central portion and a peripheral portion. However, in order to make the suction of the wafer W easier, it is preferable that the suction region 61 is divided into the central portion and the peripheral portion of the holding surface 7a. Further, in order to make holding of the wafer easier in a method of sequentially repeating partial suction of the wafer W which will be described later, the peripheral portion is preferably divided into at least four suction regions 61, more preferably 4 to 12 suction regions 61, and further more preferably 4 to 8 suction regions 61.

The suction regions 61A to 61I may be divided into a plurality of groups. For example, the suction regions 61A and 61B may be set to one group; the suction regions 61C and 61D may be set to one group; the suction regions 61E and 61F may be set to one group; and the suction regions 61G and 61H may be set to one group. The suction state and the non-suction state may be switched on a group basis.

### (Gas ejection unit)

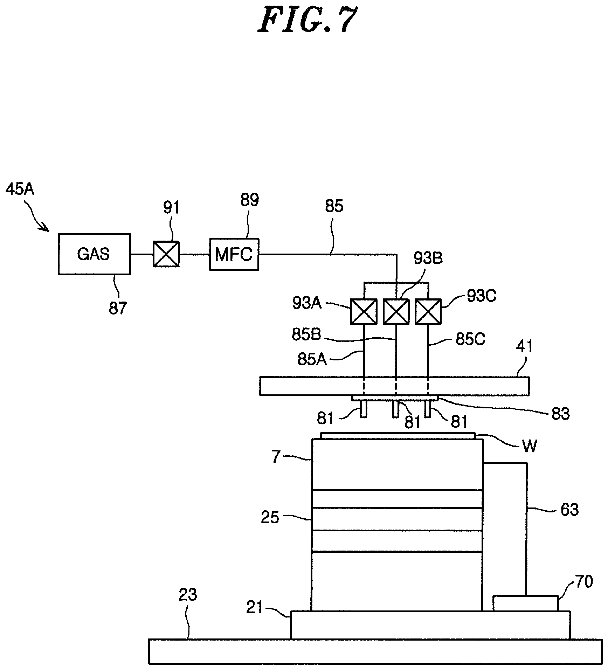

Hereinafter, a detailed configuration of the gas ejection unit 45 will be described with reference to Fig. 7. Fig. 7 explains positional relation between the gas ejection unit 45 and the wafer W held on the stage 7. In the present embodiment, the gas ejection unit 45 includes: a plurality of (e.g., three) nozzles 81 for ejecting a gas toward the top surface of the wafer W locally; a nozzle plate 83 for holding the nozzles 81; a line 85 for supplying the gas to the respective nozzles 81 while being connected to the respective nozzles 81; and a gas source 87 connected to the other end of the line 85. A mass flow controller MFC for controlling a flow rate and an opening/closing valve 91 are provided in the line 85. As for the gas, it is possible to use, e.g., dry air, nitrogen gas, rare gas or the like. The nozzles 81 are connected to the gas source 87 through branch lines 85A to 85C of the line 85, respectively. The branch lines 85A to 85C are provided with opening/closing valves 93A to 93C, respectively.

A heating gas may be used as the gas ejected from the gas ejection unit 45. In that case, a temperature of the heating gas is preferably the same as that of the holding surface 7a. For example, the temperature of the heating gas is preferably set within a range of ±10°C with respect to the temperature of the holding surface 7a of the stage 7 and more preferably set within a range of ±5°C with respect to the temperature of the holding surface 7a of the stage 7. For example, when the temperature of the holding surface 7a of the stage 7 is 120°C, the temperature of the heating gas is preferably within a range from 110°C to 130°C and more preferably within a range from 115°C to 125°C. For example, when the temperature of the holding surface 7a of the stage 7 is 150°C, the temperature of the heating gas is preferably within a range from 140°C to 160°C and more preferably within a range from 145°C to 155°C.

By using the heating gas as the gas ejected from the gas ejection unit 45, the wafer W can be heated from the top surface side thereof. Accordingly, a temperature difference between the top surface and the backside of the wafer W mounted on the holding surface 7a of the stage 7 can be minimized and, thus, it is possible to suppress warpage of the wafer W during the heating. Especially, when the wafer W has a laminated structure of different resins, the wafer W is easily warped due to a difference in thermal expansion coefficients between materials. Therefore, it is effective to use the heating gas to suppress the warpage of the wafer W. Further, since the wafer W can be heated from the top surface side by the heating gas, the wafer W made of a thermoplastic resin has improved flexibility. As a result, the suction of the wafer W by the holding surface 7a of the stage 7 becomes easier.

In the present embodiment, the nozzle plate 83 is held by the alignment unit 41. Therefore, the three nozzles 81 can move in the Y direction in Fig. 1. The stage 7 can move in the X-Y-Z direction in Fig. 1 by the X direction moving unit 21, the Y direction moving unit 23 and the Z direction moving unit 25. Accordingly, the gas can be ejected from the respective nozzles 81 separately toward target portions of the wafer W held by the stage 7. In the present embodiment, the gas can be ejected at different timings toward the nine suction regions 61A to 611 divided on the holding surface 7a of the stage 7. For example, in Fig. 3, gas ejection positions 61A1, 61B1, 61C1, 61D1, 61E1, 61F1, 61G1, 61H1 and 61I1 are indicated by virtual lines on the nine suction regions 61A to 61I. Therefore, the gas is ejected to each of nine positions on the wafer W held on the stage 7 which correspond to the suction regions 61A to 611.

The number of the nozzles 81 is not limited to three and may be, e.g., one, two, or four or more. Nine nozzles 81 may be provided to correspond to the respective suction regions 61A to 611.

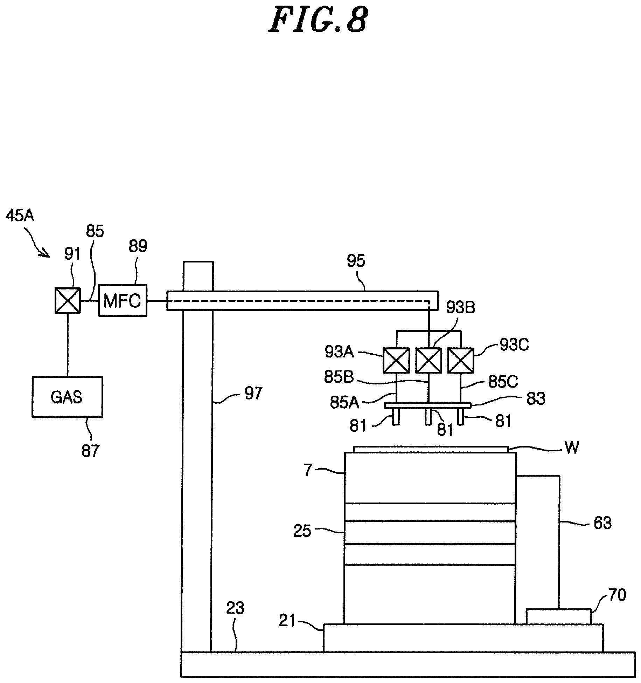

The gas ejection unit 45 and the alignment unit 41 may be provided independently. For example, Fig. 8 shows a configuration example in which the nozzle plate 83 is supported by an independent supporting portion. The gas ejection unit 45A includes: a plurality of (e.g., three) nozzles 81 for ejecting a gas toward the top surface of the wafer W locally; a nozzle plate 83 for holding the respective nozzles 81; a line 85 for supplying a gas into the respective nozzles 81 while being connected to the respective nozzles 81; a gas source 87 connected to the other end of the line 85; a nozzle arm 95 for holding the nozzle plate 83; and a column 97 for supporting the nozzle arm 95. The nozzle arm 95 is configured to be extensible/contractible, rotatable and vertically movable in the X-Y-Z direction by a driving unit (not shown). By moving the nozzle arm 95 to a position directly above the wafer W held on the holding surface 7a of the stage 7, the gas can be ejected to a predetermined portion on the wafer W.

### (Control unit)

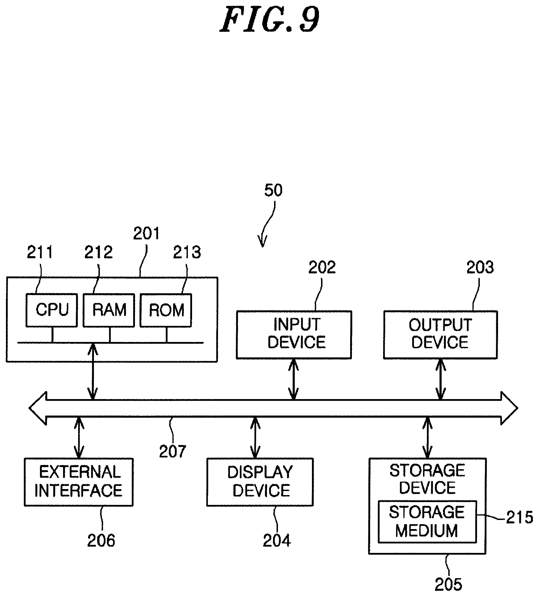

A control unit 50 controls operations of the respective components of the probe apparatus 100. The control unit 50 is typically a computer. Fig. 9 shows an example of a hardware configuration of the control unit 50. The control unit 50 includes: a main controller 201; an input device 202 such as a keyboard, a mouse or the like; an output device 203 such as a printer or the like; a display device 204; a storage device 205; an external interface 206; and a bus 207 for connecting these components. The main controller 201 has a CPU (central processing unit) 211, a RAM (random access memory) 212 and a ROM (read-only memory) 213. Types of the storage device 205 may vary as long as information can be stored. The storage device 205 may be, e.g., a hard disk device or an optical disk device. Further, the storage device 205 stores information in a computer-readable recording medium 215 and reads out the information from the recording medium. Types of the recording medium 215 may vary as long as information can be stored. The recording medium 215 may be, e.g., a hard disk, an optical disk, a flash memory or the like. The recording medium 215 may store a recipe of a probe method performed in the probe apparatus 100 of the present embodiment.

The control unit 50 controls the probe apparatus 100 of the present example to inspect devices formed on a plurality of wafers W. Specifically, the control unit 50 controls the respective components of the probe apparatus 100 (e.g., a driving device such as the motor 23b or the like, a position detecting device such as the encoder 23c or the like, the lower image pickup unit 35, the upper image pickup unit 43, the gas ejection unit 45, the vacuum chuck mechanism 60 and the like), which is realized by allowing the CPU 211 to execute software (program) stored in the ROM 213 or the storage device 205 by using the RAM 212 as a work area.

In the probe apparatus 100 configured as described above, the electrodes of the devices and the probe needles are brought into contact with each other by controlling a relative position between the wafer W held on the stage 7 and the probe card by moving the stage 7 in the horizontal direction (X direction, Y direction, θ direction) and in the vertical direction (Z direction). The test head 5 allows an inspection current to flow to the device through the probe needles of the probe card. The probe card transmits an electrical signal indicating electrical characteristics of the devices to the test head 5. The test head 5 stores the transmitted electrical signal as measurement data and determines whether or not the device as an inspection target has electrical defects.

### (Method for holding a wafer)

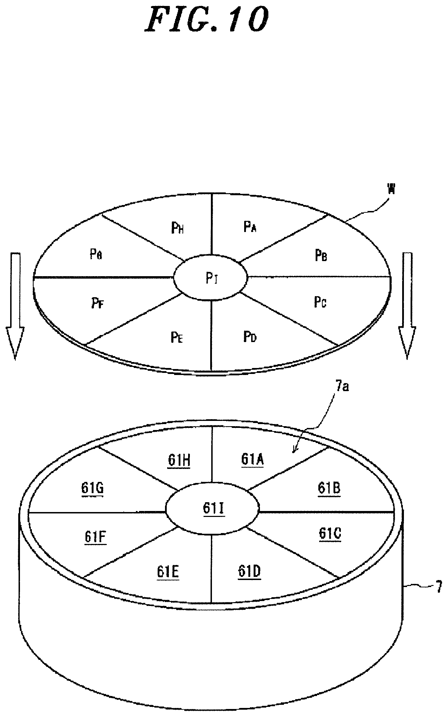

Next, a method for holding a wafer W according to an example will be described. First, relation between the suction regions 61A to 611 of the holding surface 7a of the stage 7 and portions of the wafer W which are sucked by the suction regions 61A to 611 will be described with reference to Fig. 10. Here, a portion of the wafer W which is sucked by the suction region 61A of the stage 7 is referred to as a section P_{A}. Similarly, a portion of the wafer W which is sucked by the suction region 61B is referred to as a section P_{B} ; a portion of the wafer W which is sucked by the suction region 61C is referred to as a section P_{C} ; a portion of the wafer W which is sucked by the suction region 61D is referred to as a section P_{D} ; a portion of the wafer W which is sucked by the suction region 61E is referred to as a section P_{E}; a portion of the wafer W which is sucked by the suction region 61F is referred to as a section P_{F}; a portion of the wafer W which is sucked by the suction region 61G is referred to as a section P_{G}; a portion of the wafer W which is sucked by the suction region 61H is referred to as a section P_{H}; and a portion of the wafer W which is sucked by the suction region 611 is referred to as a section P_{I}.

### (First sequence)

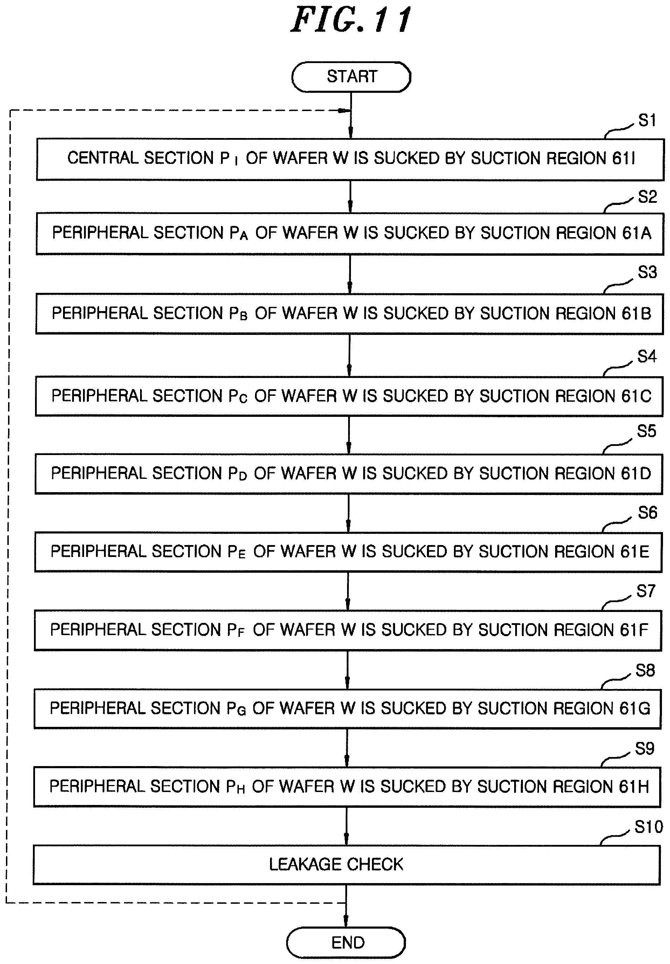

Fig. 11 is a flowchart for explaining an example of a sequence of the method for holding the wafer W according to the example. This sequence includes processes from a step S1 to a step S10. First, as a preparation step, the wafer W is mounted on the holding surface 7a of the stage 7 by a transfer unit (not shown).

### (Step S1)

In a step S1, the section P_{I} that is a central portion of the wafer W is sucked by the suction region 611. First, any one of the nozzles 81 in the gas ejection unit 45 is moved to a position directly above the section P_{I} of the wafer W. Next, the vacuum pump 70 is driven while a gas is ejected from the nozzle 81 toward the section P_{I} of the wafer W. At this time, the suction groove 7b in the suction region 611 is set to a negative pressure by switching the switching valve 651. However, the suction grooves 7b in the suction regions 61A to 61H are exposed to the atmosphere. The section P_{I} that is the central portion of the wafer W is sucked by the suction region 611 positioned therebelow due to a negative pressure at the backside of the wafer W while being assisted by a pressure of the gas ejected from the top.

### (Step S2)

Next, in a step S2, the section P_{A} in the peripheral portion which is adjacent to the section P_{I} of the wafer W is sucked by the suction region 61A of the stage 7. First, any one of the nozzles 81 in the gas ejection unit 45 is moved to a position directly above the section P_{A} of the wafer W. Next, the gas is ejected from the nozzle 81 toward the section P_{A} of the wafer W and the suction groove 7b in the suction region 61A is set to a negative pressure by switching the switching valve 65A. At this time, the suction grooves 7b in the suction regions 61B to 61H are exposed to the atmosphere. The suction groove 7b in the suction region 61I is maintained at the negative pressure as in the step S1. The section P_{A} in the peripheral portion of the wafer W is sucked by the suction region 61A positioned therebelow due to a negative pressure at the backside of the wafer W while being assisted by a pressure of the gas ejected from the top.

### (Step S3)

Next, in a step S3, the section P_{B} in the peripheral portion which is adjacent to the section P_{A} of the wafer W is sucked by the suction region 61B of the stage 7. Specific sequences are the same as those in the step S2 except that the gas is ejected from the nozzle 81 moved to a position directly above the section P_{B} of the wafer W and the suction groove 7b in the suction region 61B is set to a negative pressure by switching the switching valve 65B.

### (Steps S4 to S9)

Next, in steps S4 to S9, a section in the peripheral portion which is adjacent to the section of the wafer W which is sucked in a previous step is sucked by the suction region of the stage 7 in the order of the suction regions 61C, 61D, 61E, 61F, 61G and 61H. Specific sequences in the steps S4 to S9 are the same as those in the step S2 and S3 except that the gas is ejected from the nozzle 81 moved to a position directly above a target section among the sections P_{C} to P_{H} of the wafer W to the respective portions sequentially and the suction grooves 7b in the suction regions 61C to 61H are sequentially set to a negative pressure by sequentially switching any of the switching valves 65C to 65H.

### (Step S10)

When a normal state is obtained after the steps S1 to S9, the wafer W can be sucked by the entire holding surface 7a of the stage 7. However, when the wafer W is warped considerably, external air enters the suction groove 7b in any of the suction regions 61A to 61I and leakage occurs, which may result in incomplete holding of the wafer W. Therefore, in this sequence, leakage detection is performed in a step S10. Specifically, it is possible to determine whether or not leakage has occurred in any of the suction regions 61A to 61I by measuring a pressure in the suction line 63 by the vacuum gauge 73 and comparing the measured pressure with a previously measured pressure in the suction line 63 in a normal attraction/holding state. When it is determined in the step S10 that the leakage has occurred, the processing returns to the step S1 as indicated by a dashed line in Fig. 11 and the processes from the steps S1 to S9 are performed.

In Fig. 11, the leakage detection is collectively performed for all the suction regions 61A to 611. However, the leakage detection may be performed for each of the suction regions 61A to 61I by providing the vacuum gauge 73 for each of the lines 63A to 631, for example. In that case, the leakage detection may be performed in each of the steps S1 to S9. Or, the suction regions 61A to 6AI is divided into a plurality of groups and the leakage detection may be performed on a group basis. After the leakage detection, the suction process may be performed only for a region where the leakage has been detected among the suction regions 61A to 61I or only for a group where the leakage has been detected. The leakage detection in the step S10 is not necessary and may be omitted.

In this sequence, the entire wafer W can be easily attracted and held on the holding surface 7a of the stage 7 by repeating the operation of ejecting the gas to the wafer W locally and allowing the wafer W to be partially sucked by the suction regions 61A to 611. Especially, a section in the peripheral portion of the wafer W which is adjacent to the previously sucked section is sequentially sucked by the suction regions 61A to 61H while using a gas pressure. Therefore, even if the wafer W is warped considerably, for example, the wafer W can be reliably attracted and held on the holding surface 7a. Accordingly, the probe apparatus 100 can inspect the devices with high reliability.

### (Second sequence)

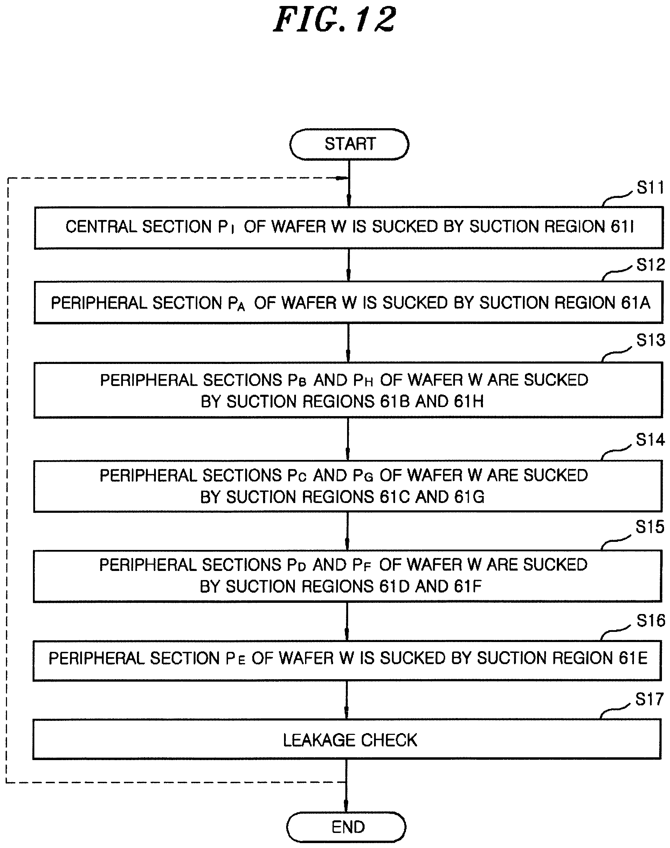

Fig. 12 is a flowchart for explaining another example of the sequence of the method for holding the wafer W according to the example. This sequence includes processes from steps S11 to S17. First, as a preparation step, the wafer W is mounted on the holding surface 7a of the stage 7 by a transfer unit (not shown).

### (Step S11)

In a step S11, the section P_{I} as the central portion of the wafer W is sucked by the suction region 611. The step S11 may be executed in the same manner as that in the step S1 of the first sequence.

### (Step S12)

Next, in a step S12, the section P_{A} in the peripheral portion which is adjacent to the section P_{I} of the wafer W is sucked by the suction region 61A of the stage 7. First, one of the nozzles 81 in the gas ejection unit 45 is moved to a position directly above the section P_{A} of the wafer W. Next, the gas is ejected from the nozzle 81 toward the section P_{A} of the wafer W and the suction groove 7b in the suction region 61A is set to a negative pressure by switching the switching valve 65A. At this time, the suction grooves 7b in the suction regions 61B to 61H are exposed to the atmosphere. The suction groove 7b in the suction region 61I is maintained at the negative pressure as in the step S11. The section P_{A} in the peripheral portion of the wafer W is sucked by the suction region 61A positioned therebelow due to a negative pressure at the backside of the wafer W while being assisted by a pressure of the gas ejected from the top.

### (Step S13)

Next, in a step S13, two sections P_{B} and P_{H} in the peripheral portion which are adjacent to the section P_{A} of the wafer W are sucked by the suction regions 61B and 61H of the stage 7, respectively. Specific sequences are the same as those in the step S12 except that the gas is ejected from two nozzles 81 moved to positions directly above the sections P_{B} and P_{H} of the wafer W toward the respective portions at the same time and the suction grooves 7b in the suction regions 61B and 61H are set to the negative pressure at the same time by switching the switching valves 65B and 65H.

### (Step S14)

Next, in a step S14, two sections P_{C} and P_{G} in the peripheral portion which are adjacent to the sections P_{B} and P_{H} of the wafer W are sucked by the suction regions 61C and 61G of the stage 7, respectively. Specific sequences are the same as those in the step S12 except that the gas is ejected from two nozzles 81 moved to positions directly above the sections P_{C} and P_{G} of the wafer W toward the respective portions at the same time and the suction grooves 7b in the suction regions 61C and 61G are set to the negative pressure at the same time by switching the switching valves 65C and 65G.

### (Step S15)

Next, in a step S15, two sections P_{D} and P_{F} in the peripheral portion which are adjacent to the sections P_{C} and P_{G} of the wafer W are sucked by the suction regions 61D and 61F of the stage 7, respectively. Specific sequences are the same as those in the step S12 except that the gas is ejected from two nozzles 81 moved to positions directly above the sections P_{D} and P_{F} of the wafer W toward the respective portions at the same time and the suction grooves 7b in the suction regions 61D and 61F are set to the negative pressure at the same time by switching the switching valves 65D and 65F.

### (Step S16)

Next, in a step S16, a section P_{E} in the peripheral portion which is adjacent to the sections P_{D} and P_{F} of the wafer W is sucked by the suction region 61E of the stage 7. Specific sequences are the same as those in the step S12 except that the gas is ejected from the nozzle 81 moved to a position directly above the section P_{E} of the wafer W and the suction groove 7b in the suction region 61E is set to the negative pressure by switching the switching valve 65E.

### (Step S17)

When a normal state is obtained after the steps S11 to S16, the wafer W can be sucked by the entire holding surface 7a of the stage 7. However, when the wafer W is warped considerably, external air enters the suction groove 7b in any one of the suction regions 61A to 61I and leakage occurs, which may result in incomplete holding of the wafer W. Therefore, in this sequence, leakage detection is performed in a step S17. The leakage detection is performed in the same manner as that in the step S10 of the first sequence. When it is determined in the step S17 that the leakage has occurred, the processing returns to the step S11 as indicated by a dashed line in Fig. 12 and the processes from the steps S11 to S16 are performed.

In Fig. 12, the leakage detection is collectively performed for all the suction regions 61A to 611. However, the leakage detection may be performed for each of the suction regions 61A to 61I by providing the vacuum gauge 73 for each of the lines 63A to 63I, for example. In that case, the leakage detection may be performed in each of the steps S11 to S16. Or, the suction regions 61A to 6AI is divided into a plurality of groups and the leakage detection may be performed on a group basis. After the leakage detection, the suction process may be performed only for a region where the leakage has been detected among the suction regions 61A to 611 or only for a group where the leakage has been detected. The leakage detection in the step S17 is not necessary and may be omitted.

In this sequence, since two sections in the peripheral portion of the wafer W which are adjacent to the previously sucked section are sucked at the same time, the attraction and holding of the wafer W can be completed within a short period of time compared to the method for holding the wafer W based on the first sequence. The other configurations and effects in this sequence are the same as those in the first sequence.

### (Third sequence)

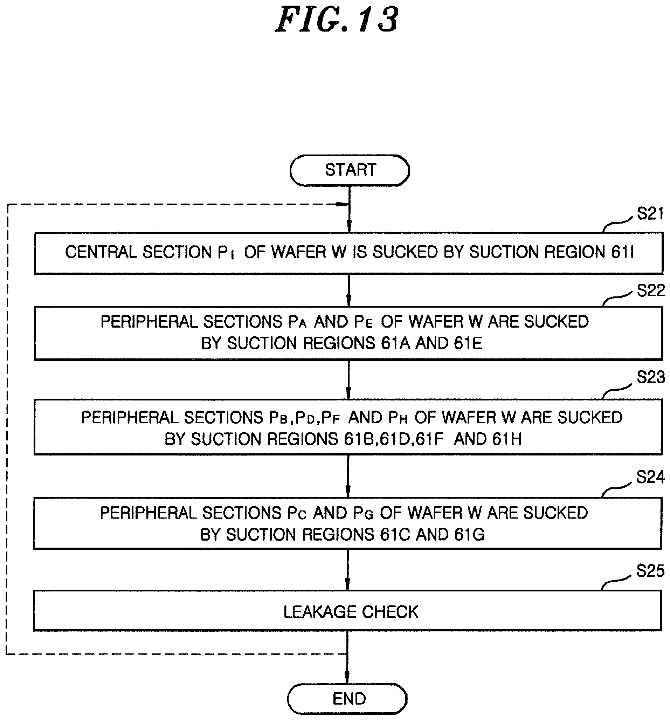

Fig. 13 is a flowchart for explaining still another example of the method for holding the wafer W according to the example. This sequence includes processes from steps S21 to S25. First, as a preparation step, the wafer W is mounted on the holding surface 7a of the stage 7 by a transfer unit (not shown).

### (Step S21)

In a step S21, a section P_{I} that is a central portion of the wafer W is sucked by the suction region 611. The step S21 may be executed in the same manner as that in the step S1 of the first sequence.

### (Step S22)

Next, in a step S22, a section P_{A} in the peripheral portion of the wafer W which is adjacent to the section P_{I} and a section P_{E} positioned diametrically symmetrical to the section P_{A} are sucked by the suction regions 61A and 61E of the stage 7, respectively. First, one of the nozzles 81 in the gas ejection unit 45 is moved to a position directly above the sections P_{A} and P_{E} of the wafer W. Then, the gas is ejected from the nozzle 81 toward the sections P_{A} and P_{E} of the wafer W and the suction grooves in the suction regions 61A and 61E are set to the negative pressure at the same time by switching the switching valves 65A and 65E. At this time, the suction grooves 7b in the suction regions 61B to 61D and 61F to 61H are exposed to the atmosphere. The suction groove 7b in the suction region 611 is maintained at the negative pressure as in the step S21. The sections P_{A} and P_{E} in the peripheral portion of the wafer W are sucked by the suction regions 61A and 61E positioned therebelow due to a negative pressure at the backside of the wafer W while being assisted by a pressure of the gas ejected from the top.

### (Step S23)

Next, in a step S23, two sections P_{B} and P_{H} in the peripheral portion which are adjacent to the section P_{A} of the wafer W are sucked by the suction regions 61B and 61H of the stage 7, respectively. At the same time, two sections P_{D} and P_{F} in the peripheral portion which are adjacent to the section P_{E} of the wafer W are sucked by the suction regions 61D and 61F, respectively. Specific sequences are the same as those in the step S22 except that the gas is ejected from four nozzles 81 moved to positions directly above the sections P_{B}, P_{H}, P_{D} and P_{F} of the wafer W toward the respective portions at the same time and the suction grooves 7b in the suction regions 61B, 61H, 61D and 61F are set to the negative pressure at the same time by switching the switching valves 65B, 65H, 65D and 65F.

### (Step S24)

Next, in a step S24, two remaining sections P_{C} and P_{G} in the peripheral portion of the wafer W are sucked by the suction regions 61C and 61G of the stage 7, respectively. Specific sequences are the same as those in the step S22 except that the gas is ejected from two nozzles 81 moved to positions directly above the sections P_{C} and P_{G} of the wafer W toward the respective portions at the same time and the suction grooves 7b in the suction regions 61C and 61G are set to the negative pressure at the same time by switching the switching valves 65C and 65G.

### (Step S25)

When a normal state is obtained after the steps S21 to S24, the wafer W can be sucked by the entire holding surface 7a of the stage 7. However, when the wafer W is warped considerably, external air enters the suction groove 7b in any one of the suction regions 61A to 61I and leakage occurs, which may result in incomplete holding of the wafer W. Therefore, in this sequence, leakage check is performed in a step S25. The leakage check is performed in the same manner as that in the step S10 of the first sequence. When it is determined in the step S25 that the leakage has occurred, the processing returns to the step S21 as indicated by a dashed line in Fig. 13 and the processes from the steps S21 to S24 are performed.

In Fig. 13, the leakage check is performed for all the suction regions 61A to 61I. However, the leakage check may be performed for each of the suction regions 61A to 61I by providing the vacuum gauge 73 for each of the lines 63A to 63I, for example. In that case, the leakage check may be performed in each of the steps S21 to S24. Or, the suction regions 61A to 6AI is divided into a plurality of groups and the leakage check may be performed on a group basis. After the leakage check, the suction process may be performed only for a region where the leakage has been detected among the suction regions 61A to 61I or only for a group where the leakage has been detected. The leakage check in the step S25 is optional and may be omitted.

In this sequence, first, two portions in the peripheral portion of the wafer W are sucked at the same time. Then, four or less number of portions in the peripheral portion which are adjacent to the previously sucked portions are sucked at the same time. Therefore, the attraction and holding of the wafer W can be completed within a short period of time compared to the method for holding the wafer W based on the first sequence. The other configurations and effects in this sequence are the same as those in the first sequence.

As described above, the method for holding the wafer W based on the first to the third sequence enables the wafer W that is likely to warp considerably to be reliably attracted and held. Fig. 3 shows the case in which eight suction regions 61A to 61H that suck the peripheral portion of the wafer W have the same shape and the same area. However, the suction regions 61 may have different areas or different shapes. Hereinafter, modifications in which the suction regions 61 have different areas or different shapes will be described.

### (Modification)

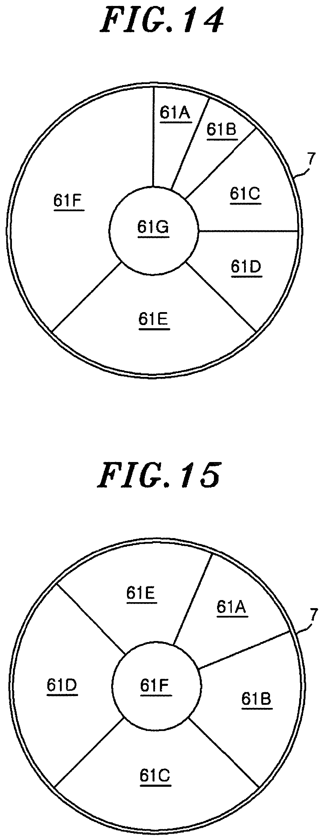

Modifications of the method for holding the wafer W according to the example will be described with reference to Figs. 14 to 16. In Figs. 14 to 16, the suction grooves 7b are not illustrated, and locations, shapes and areas of the suction regions 61 on the holding surface 7a of the stage 7 are schematically illustrated. In the following description, only the sequence in which the wafer W is partially sucked by the respective suction regions 61 will be described. As in the first to the third sequence, the gas needs to be ejected from any one of the nozzles 81 in the gas ejection unit 45 during the suction operation. The leakage detection may be performed in the modifications.

### (First modification)

First, in the first modification shown in Fig. 14, the holding surface 7a of the stage 7 is divided into seven suction regions 61A, 61B, 61C, 61D, 61E, 61F and 61G by the suction grooves 7b that can be maintained in a depressurized state separately. The suction region 61G is a central region provided at the central portion of the holding surface 7a having a circular shape when seen from the top. The suction regions 61A, 61B, 61C, 61D, 61E and 61F are peripheral regions provided around the suction region 61G on the holding surface 7a having the circular shape when seen from the top. Here, the suction regions 61A to 61F include regions having different areas. Specifically, the suction regions 61A and 61B have the same area and the suction regions 61C and 61D have the same area. However, the suction regions 61C and 6D are greater than the suction regions 61A and 61B. The suction region 61E is greater than the suction regions 61C and 61D. The suction region 61F is greater than the suction region 61E. In other words, the areas of the suction regions 61A to 61F satisfy the following relation "the suction region 61A = the suction region 61B < the suction region 61C = the suction region 61D < the suction region 61E < the suction region 61F".

In the first modification shown in Fig. 14, first, the central portion of the wafer W is sucked by the suction region 61G and, then, the peripheral portion of the wafer W is partially and sequentially sucked by the suction regions 61A to 61F from the smallest area to the largest area. Specifically, a section in the peripheral portion of the wafer W is sucked by the suction region 61A. Next, a section in the peripheral portion of the wafer W, which is adjacent to the section sucked by the suction region 61A, is sucked by the suction region 61B. Next, a section in the peripheral portion of the wafer W, which is adjacent to the section sucked by the suction region 61B, is sucked by the suction region 61C. Next, a section in the peripheral portion of the wafer W, which is adjacent to the section sucked by the suction region 61C, is sucked by the suction region 61D. Next, a section in the peripheral portion of the wafer W, which is adjacent to the portion sucked by the suction region 61D, is sucked by the suction region 61E. Next, a section in the peripheral portion of the wafer W, which is adjacent to the section sucked by the suction region 61E, is sucked by the suction region 61F. By allowing the wafer W to be sucked by the suction regions 61A to 61F from the smallest area to the largest area, the wafer W can be attracted and held on the entire holding surface 7a of the stage 7.

### (Second modification)

First, in the second modification shown in Fig. 15, the holding surface 7a of the stage 7 is divided into six suction regions 61A, 61B, 61C, 61D, 61E and 61H by the suction grooves 7b that can be maintained in a depressurized state separately. The suction region 61F is a central region provided at the central portion of the holding surface 7a having a circular shape when seen from the top. The suction regions 61A, 61B, 61C, 61D and 61E are peripheral regions provided around the suction region 61F on the holding surface 7a having the circular shape when seen from the top. Here, the suction regions 61A to 61E include regions having different areas. Specifically, the suction region 61A has the smallest area. The suction regions 61B and 61E have the same area. The suction regions 61B and 6E are greater than the suction region 61A. The suction regions 61C and 61D have the same area. The suction regions 61C and 61D are greater than the suction regions 61B and 61E. In other words, the areas of the suction regions 61A to 61E satisfy the following relation "the suction region 61A < the suction region 61B = the suction region 61E < the suction region 61C = the suction region 61D".

In the second modification shown in Fig. 15, first, the central portion of the wafer W is sucked by the suction region 61F and, then, the peripheral portion of the wafer W is partially and sequentially sucked by the suction regions 61A to 61E from the smallest area to the largest area. Specifically, a section in the peripheral portion of the wafer W is sucked by the suction region 61A. Next, sections in the peripheral portion of the wafer W, which are adjacent to the section sucked by the suction region 61A, are sucked by the suction regions 61B and 61E. Next, sections in the peripheral portion of the wafer W, which are adjacent to the sections sucked by the suction regions 61B and 61E, are sucked by the suction regions 61C and 61D. By allowing the wafer W to be sucked by the suction regions 61A to 61E from the smallest area to the largest area, the wafer W can be attracted and held on the entire holding surface 7a of the stage 7.

### (Third modification)

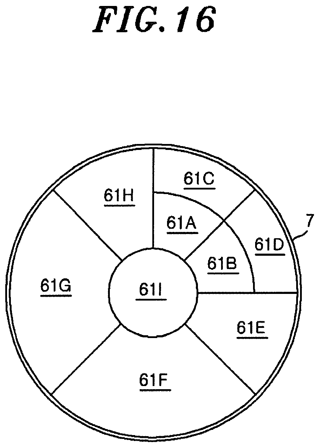

In the third modification shown in Fig. 16, the holding surface 7a of the stage 7 is divided into nine suction regions 61A, 61B, 61C, 61D, 61E, 61F, 61G, 61H and 61I by the suction grooves 7b that can be maintained in a depressurized state separately. The suction region 611 is a central region provided at the central portion of the holding surface 7a having a circular shape when seen from the top. The suction regions 61A, 61B, 61C, 61D, 61E, 61F, 61G and 61H are peripheral regions provided around the suction region 61I on the holding surface 7a having the circular shape when seen from the top. Here, the suction regions 61A to 61H include regions having different areas. Specifically, the suction regions 61A and 61B have the same area. The suction regions 61A and 61B are smallest regions in the peripheral region of the holding surface 7a of the stage 7 which are disposed at a radially inner side. The suction regions 61C and 61D have the same area. The suction regions 61C and 61D are greater than the suction regions 61A and 61B. The suction regions 61C and 61D are disposed at a radially outer side of the suction regions 61A and 61B in the peripheral region of the holding surface 7a of the stage 7. The suction regions 61E and 61H have the same area. The suction regions 61E and 61H are greater than the suction regions 61C and 61D. The suction regions 61F and 61G have the same area. The suction regions 61F and 61G are greater than the suction regions 61E and 61H. In other words, the areas of the suction regions 61A to 61H satisfy the following relation "the suction region 61A = the suction region 61B < the suction region 61C=the suction region 61D < the suction region 61E = the suction region 61H < the suction region 61F = the suction region 61G".

In the third modification shown in Fig. 16, first, the central portion of the wafer W is sucked by the suction region 61I and, then, the peripheral portion of the wafer W is partially and sequentially sucked by the suction regions 61A to 61H from the smallest area to the largest area. Specifically, sections in the peripheral portion of the wafer W are sucked by the suction regions 61A and 61B. Next, sections in the peripheral portion of the wafer W, which are adjacent to the sections sucked by the suction regions 61A and 61B, are sucked by the suction regions 61C and 61D, respectively. Next, sections in the peripheral portion of the wafer W, which are adjacent to the portions sucked by the suction regions 61C and 61D, are sucked by the suction regions 61E and 61H, respectively. Next, the sections in the peripheral portion of the wafer W, which are adjacent to the sections sucked by the suction regions 61E and 61H, are sucked by the suction regions 61G and 61F, respectively. By allowing the wafer W to be partially and sequentially sucked by the suction regions 61A to 61H from the smallest area to the largest area, the wafer W can be attracted and held on the entire holding surface 7a of the stage 7.

As described above, in the first to the third modification, a plurality of suction regions 61 for sucking the peripheral portion of the wafer W includes two or more suction regions 61 having different areas. The peripheral portion of the wafer W can be partially and sequentially sucked by the suction regions 61 from the smallest area to the largest area. Accordingly, even when the wafer W is warped considerably and only a smaller section thereof is sucked at first, the warpage of the wafer W can be gradually reduced by increasing the suction area by sequentially sucking sections adjacent thereto. As a result, the entire surface of the wafer W can be attracted and held on the entire holding surface 7a of the stage 7.

By changing the area and the shape of the suction regions 61, the number of the suction regions 61 (i.e., the number of divided portions of the holding surface 7a of the stage 7) can be reduced. Accordingly, the configuration of the apparatus can be simplified.

### (Second embodiment)

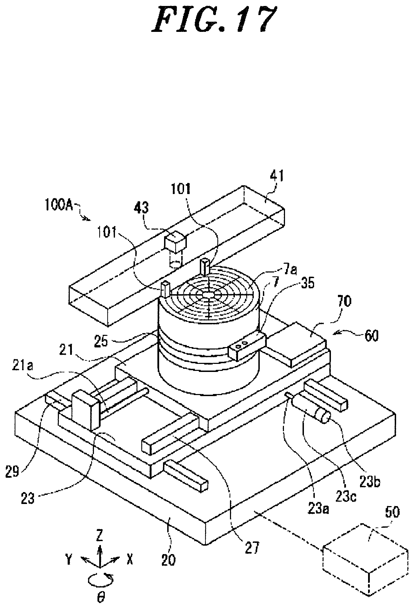

Hereinafter, a probe apparatus according to a second embodiment will be described with reference to Figs. 17 to 19. Fig. 17 is a perspective view schematically showing an inner structure of a probe apparatus 100A according to the second embodiment. The probe apparatus 100A includes, as a pressing device, a pressing unit 101 for pressing the holding surface 7a of the stage 7 while being in contact with the top surface of the sucked portion of the wafer W. In the probe apparatus 100A shown in Fig. 17, like reference numerals will designate like parts in the probe apparatus 100 according to the first example, and redundant description thereof will be omitted.

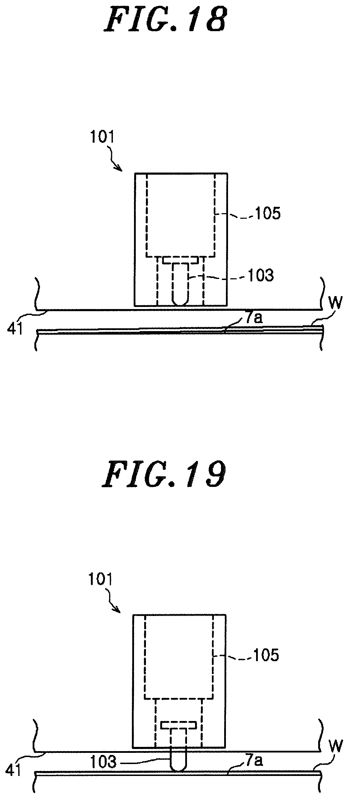

In the present embodiment, a plurality of pressing units 101 is provided at a side portion of the alignment unit 41. Figs. 18 and 19 explain one pressing unit. As can be seen from Figs. 18 and 19, the pressing unit 101 has a pressing pin 103 as a pressing member, and a driving unit 105 for vertically displacing the pressing pin 103. A leading end of the pressing pin 103 is preferably made of a material having a thermal conductivity lower than that of a metal, such as ceramic, synthetic resin, rubber or the like, and more preferably made of a heat resistant elastic material such as fluorine rubber or the like.

Although it is not illustrated, the driving unit 105 has an actuator such as an air cylinder or the like and a biasing member such as a spring or the like. As shown in Fig. 18, a leading end of the pressing pin 103 is generally held at a retreat position higher than a lower end of the alignment unit 41 by a biasing force of the biasing member. When the actuator is driven, the pressing pin 103 moves downward by a predetermined stroke beyond the lower end of the alignment unit 41 against the biasing force of the biasing member and presses a part of the wafer W by the contact between the leading end of the pressing pin 103 and the top surface of the sucked portion of the wafer W, as can be seen from Fig. 19.

The pressing pin 103 functions in the same manner as the gas ejected from the gas ejection unit 45 in the first embodiment. In other words, the pressing pin 103 presses a part of the top surface of the wafer W against the holding surface 7a of the stage 7 positioned therebelow. As a result, in the probe apparatus 100A of the second embodiment, the wafer W can be attracted and held in the same manner as that in the probe apparatus 100 of the first embodiment.

The number of the pressing units 101 is not limited to two, and may be one, or three or more. However, it is preferable to provide a plurality of pressing units 101. In the present embodiment, as shown in Fig. 17, two pressing units 101 are provided at the side portion of the alignment unit 41 and can press the sucked portion of the wafer W. Accordingly, a moving distance of the stage 7 in the XY direction in the case of attracting and holding the wafer W is decreased, which makes it possible to reduce a foot print of the entire apparatus. Further, in the present embodiment, an additional supporting mechanism is not required because the pressing units 101 are attached to the alignment unit 41. Therefore, the configuration of the apparatus can be simplified. In addition, the pressing units 101 may be supported by a separate supporting member instead of being attached to the alignment unit 41.

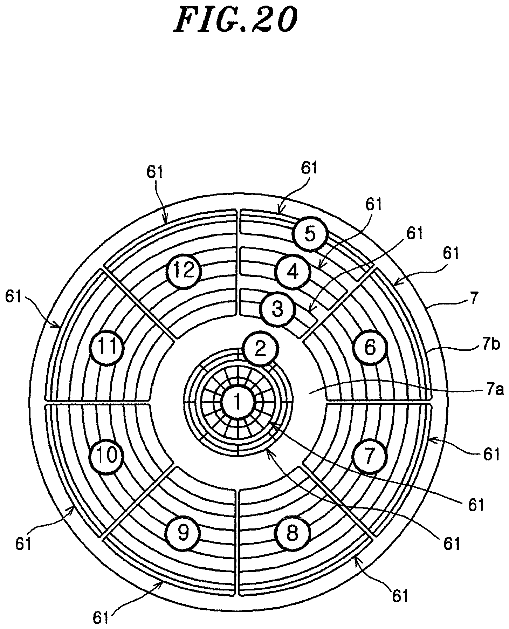

Next, a plurality of suction regions formed on the holding surface 7a of the stags 7 in the probe apparatus 100A will be described with reference to Fig. 20. In the probe apparatus 100A, the holding surface 7a of the stage 7 is divided into twelve suction regions 61 by the suction grooves 7b that can be maintained in a depressurized state separately. In Fig. 20, in order to simplify the description, the twelve suction regions 61 partitioned on the holding surface 7a of the stage 7 are indicated by numbers 1 to 12 indicating the order of sucking the wafer W.

In Fig. 20, the suction regions 61 indicated by numbers 1 and 2 are central regions provided at a central portion of the holding surface 7a having a circular shape when seen from the top. The suction regions indicated by the numbers 1 and 2 have different areas and are formed from the center of the holding surface 7a of the stage 7 toward a radially outer side. The central region may include a plurality of regions divided in a diametrical direction of the holding surface 7a.

The suction regions 61 indicated by numbers 3 to 12 are peripheral regions formed around the central regions indicated by the numbers 1 and 2 on the holding surface 7a having a circular shape when seen from the top. The suction regions indicated by the numbers 3, 4 and 5 have different areas and are formed from the center side of the holding surface 7a of the stage 7 toward a radially outer side. The peripheral region may include a plurality of regions divided in a diametrical direction of the holding surface 7a.

The other configurations and the effect in the probe apparatus 100A of the present embodiment are the same as those in the first example.

Next, a method of holding the wafer W in the probe apparatus 100A will be described. In this sequence, first, the central portion of the wafer W is sucked by the region of No. 1 and the region of No. 2 positioned at an outer side of the No. 1 region, which correspond to the central region of the holding surface 7a of the stage 7 in that order. Next, the peripheral portion of the wafer W is sucked by the region of No. 3, the region of No. 4 and the region of No. 5, which correspond to the peripheral region of the holding surface 7a of the stage 7 in that order from the center side toward the diametrically outer side. Next, the peripheral portion of the wafer W is sucked by the region of No. 6, the region of No. 7, the region of No. 8, the region of No. 9, the region of No. 10, the region of No. 11 and the region of No. 12 in that order along the circumferential direction. By repeating the operation of sucking a part of the wafer W by the region adjacent thereto, the entire wafer W can be easily attracted and held on the holding surface 7a of the stage 7. Therefore, even when the wafer W is warped, it is possible to attract and hold the entire wafer W on the holding surface 7a of the stage 7.

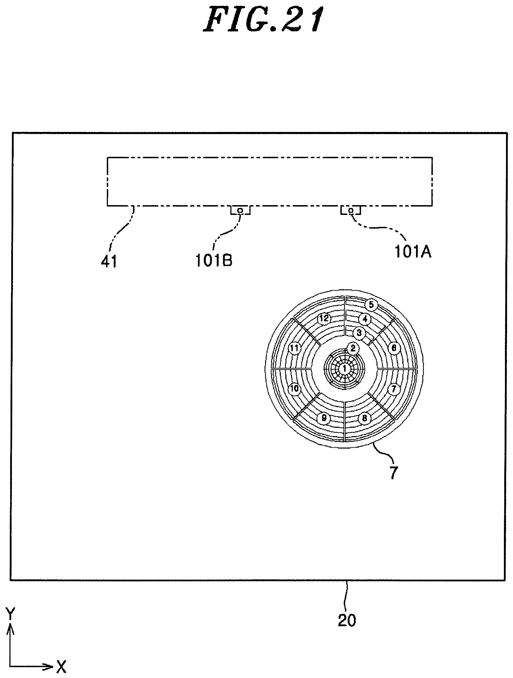

Next, a specific sequence of the method of holding the wafer W in the probe apparatus 100A will be described with reference to Figs. 21 to 33. In Figs. 21 to 33, the positional relation between the pressing pin 103 of the pressing unit 101 provided at two locations of the side portion of the alignment unit 41 and the holding surface 7a of the stage 7. For convenience of description, the two pressing units 101 are distinguished by reference numerals 101A and 101B. Numbers 1 to 12 on the holding surface 7a of the stage 7 indicate the same as those in Fig. 20. The wafer W itself is not illustrated. The alignment unit 41 can reciprocally move in the Y direction in the drawings and the stage 7 can move in the XY direction in the drawings.

In Fig. 21, the stage 7 is moved to a delivery position of the wafer W. Then, the loader unit 3 transfers the wafer W (not shown) to the holding surface 7a of the stage 7.

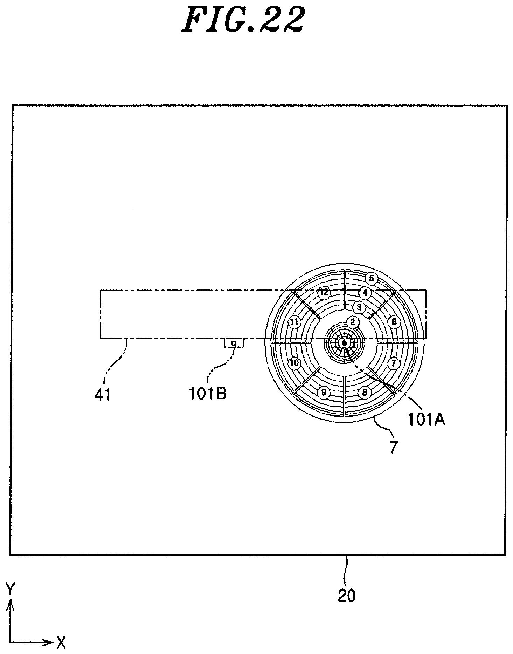

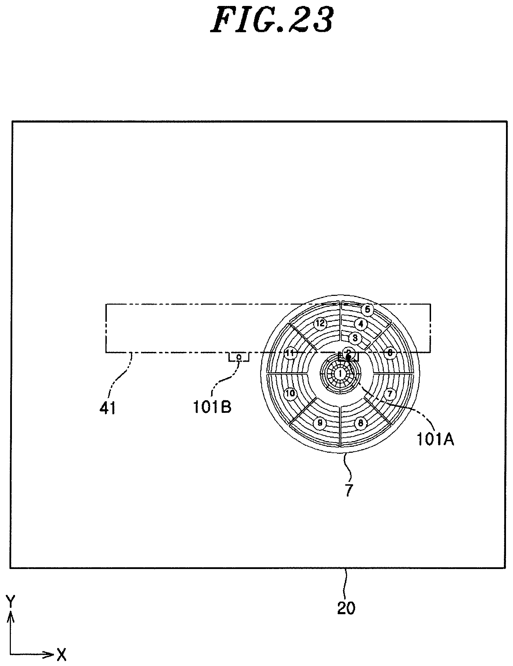

Next, as shown in Fig. 22, the alignment unit 41 is moved in the Y direction until the pressing pin 103 of the pressing unit 101A reaches a position directly above the region of No. 1. The suction of the No. 1 region is switched ON and the pressing pin 103 of the pressing unit 101A moves. Accordingly, the central portion of the wafer W is pressed and sucked by the region of No. 1. In Fig. 22, a pressing position of the pressing pin 103 is indicated by a black point (this holds true in Figs. 23 to 33). Next, the suction state is checked through the leakage check and, then, the pressing pin 103 is retreated.

Next, as shown in Fig. 23, the stage 7 is moved until the pressing pin 103 of the pressing unit 101A reaches a position directly above the region of No. 2. The suction of the No. 2 region is switched ON and the pressing pin 103 of the pressing unit 101A moves to press a radially outer side of the central portion of the wafer W, so that the wafer W is sucked by the No. 2 region. Next, the suction state is checked through the leakage check and, then, the pressing pin 103 is retreated.

The wafer W may be sucked by the No. 1 region and the No. 2 region in that order while maintaining a state in which one location at the central portion of the wafer W is pressed by the pressing pin 103 of the pressing unit 101A.

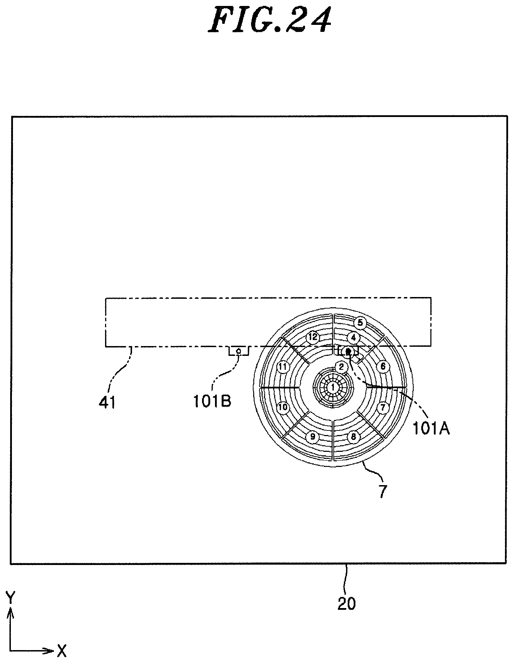

Next, as shown in Fig. 24, the stage 7 is moved until the pressing pin 103 of the pressing unit 101A reaches a position directly above the region of No. 3. The suction of the No. 3 region is switched ON and the pressing pin 103 of the pressing unit 101A moves to press a part of the wafer W, so that the wafer W is sucked by the No. 3 region. Next, the suction state is checked through the leakage check and, then, the pressing pin 103 is retreated.

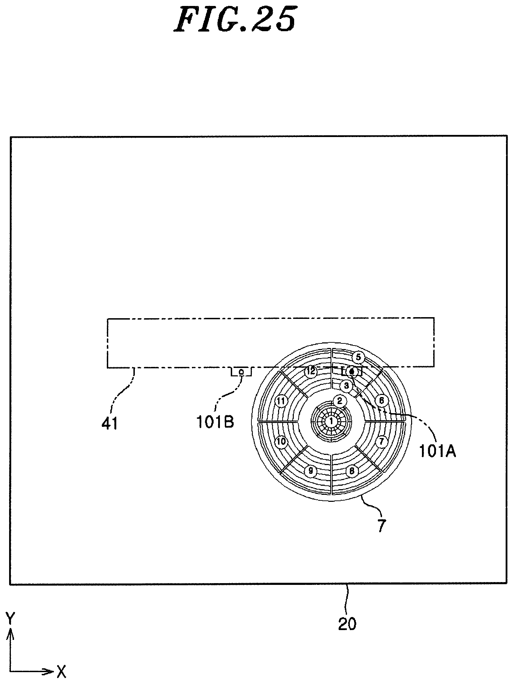

Next, as shown in Fig. 25, the stage 7 is moved until the pressing pin 103 of the pressing unit 101A reaches a position directly above the region of No. 4. The suction of the No. 4 region is switched ON and the pressing pin 103 of the pressing unit 101A moves to press a part of the wafer W, so that the wafer W is sucked by the No. 4 region. Next, the suction state is checked through the leakage check and, then, the pressing pin 103 is retreated.

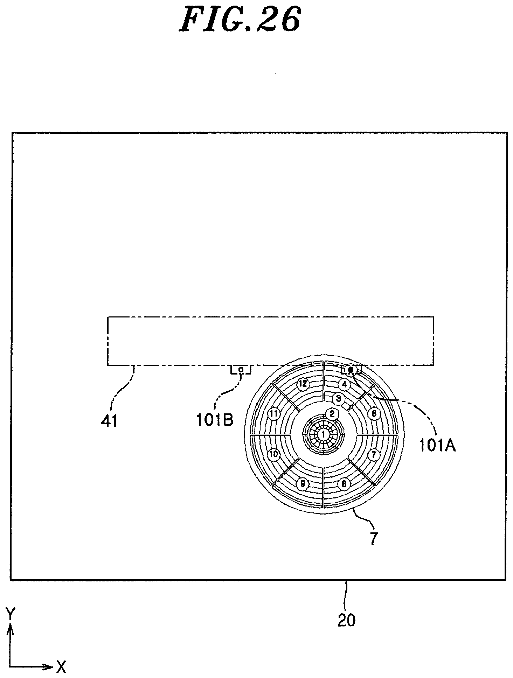

Next, as shown in Fig. 26, the stage 7 is moved until the pressing pin 103 of the pressing unit 101A reaches a position directly above the 5^{th} region. The suction of the region of No. 5 is switched ON and the pressing pin 103 of the pressing unit 101A moves to press a part of the wafer W, so that the wafer W is sucked the no. 5 region. Next, the suction state is checked through the leakage check and, then, the pressing pin 103 is retreated.

The wafer W may be sucked by the No. 3 region, the No. 4 region and the No. 5 region in that order while maintaining a state in which one location on the wafer W corresponding to any one of the regions is pressed by the pressing pin 103 of the pressing unit 101A.

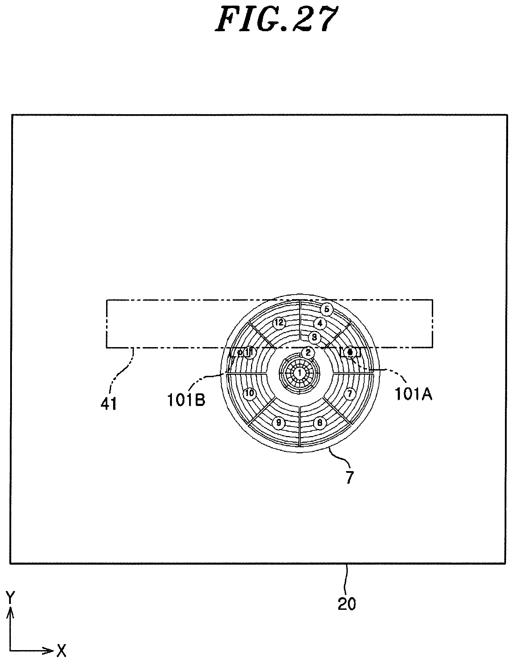

Next, as shown in Fig. 27, the stage 7 is moved until the pressing pin 103 of the pressing unit 101A reaches a position directly above the region of No. 6. The suction of the No. 6 region is switched ON and the pressing pin 103 of the pressing unit 101A moves to press a part of the wafer W, so that the wafer W is sucked by the No. 6 region. Next, the suction state is checked through the leakage check and, then, the pressing pin 103 is retreated.

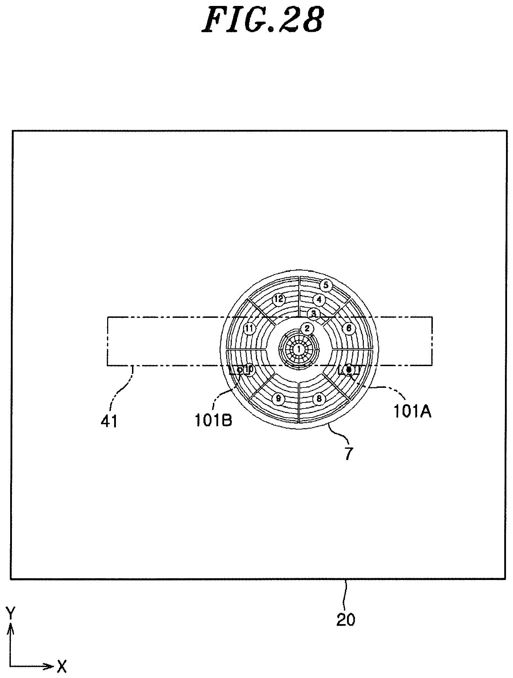

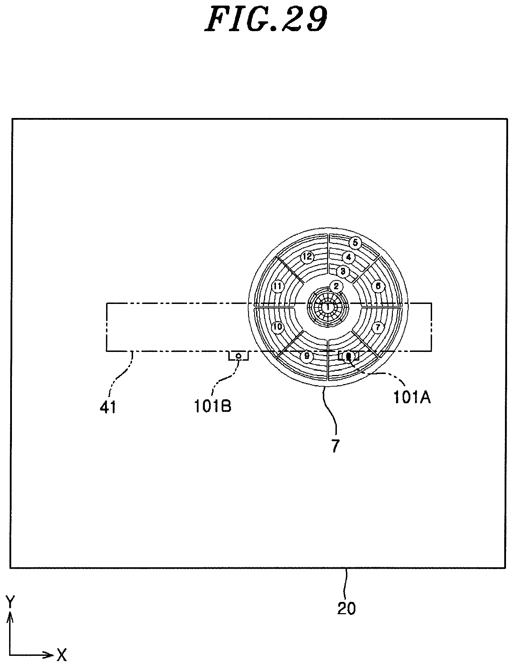

In the same manner, the wafer W is partially sucked while repeating the pressing and the retreat of the pressing pin 103 of the pressing unit 101A in the order of the region of No. 7 (see Fig. 28) and the region of No. 8 (see Fig. 29).

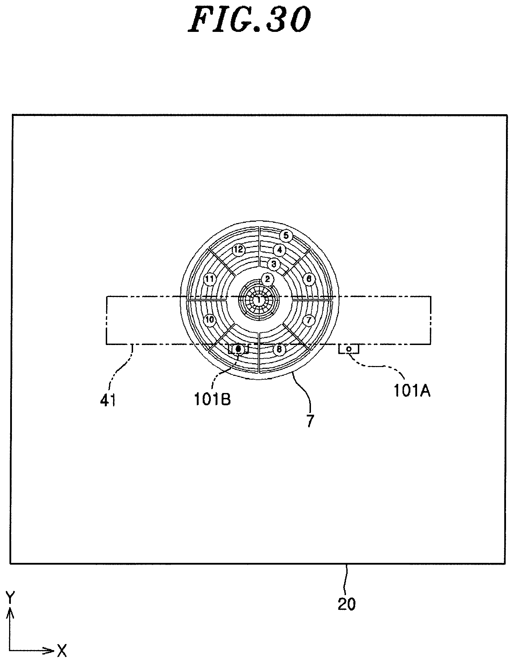

Next, as shown in Fig. 30, the pressing unit 101B is replaced with the pressing unit 101A and the stage 7 is moved until the pressing pin 103 of the pressing unit 101B reaches a position directly above the region of No. 9. The suction of the No. 9 region is switched ON and the pressing pin 103 of the pressing unit 101A moves to press a part of the wafer W, so that the wafer W is sucked by the No. 9 region. Next, the suction state is checked through the leakage check and, then, the pressing pin 103 is retreated. By replacing the pressing unit 101B with the pressing unit 101A during the process, the suction process of the wafer W can be performed without increasing the moving range of the stage 7. Accordingly, the wafer W can be reliably attracted and held without increasing the foot print of the apparatus including the X direction moving unit 21 and the Y direction moving unit 23 which are configured to move the stage 7 in the XY direction.

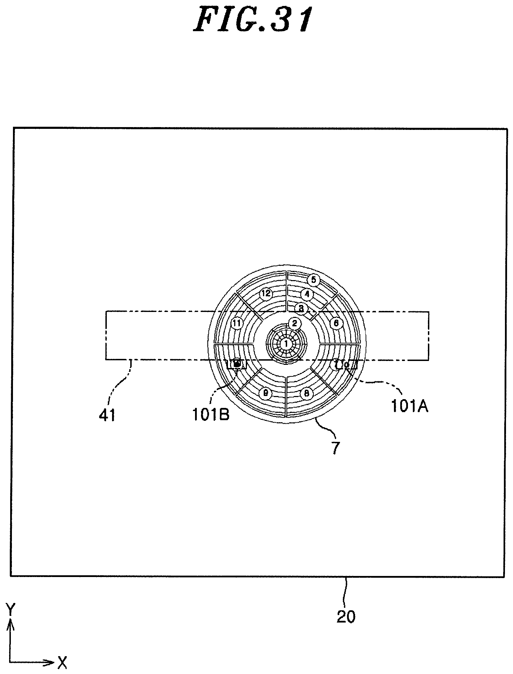

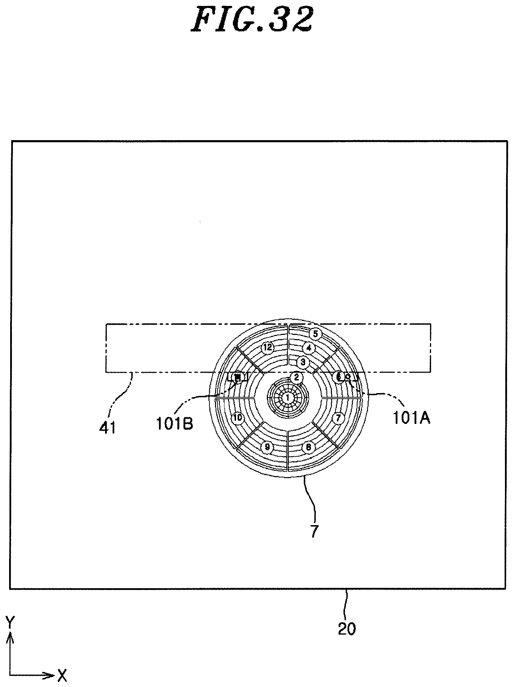

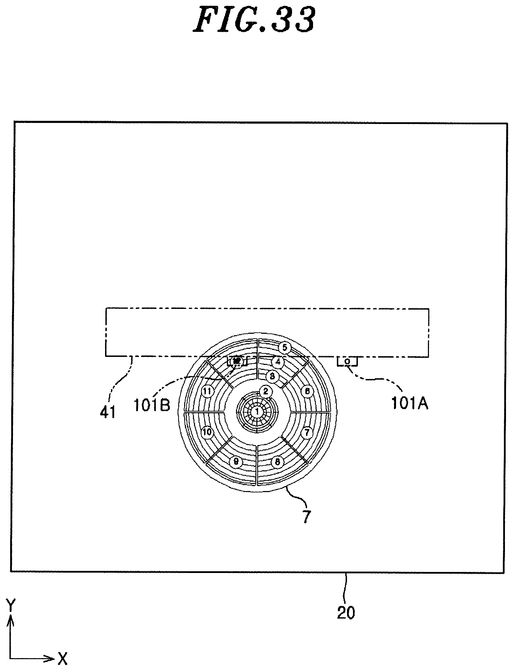

In the same manner, the wafer W is partially sucked by repeating the pressing and the retreat of the pressing pin 103 of the pressing unit 101B in the order of the region of No. 10 (see Fig. 31), the region of No. 11 (see Fig. 32) and the region of No. 12 (see Fig. 33).

By allowing the wafer W to be sucked by the No. 1 region to the No. 12 region sequentially, the wafer W can be attracted and held on the entire holding surface 7a of the stage 7. This sequence may be performed by repeating the start and the stop of gas ejection by providing the nozzle 81 of the gas ejection unit 45 of the first embodiment at two locations, instead of by repeating the pressing and the retreat of the pressing pin 103 of two pressing units 101 provided at the alignment unit 41.

While the examples and embodiments have been described in detail, the present invention is not limited to the embodiments and may be variously modified. For example, in the above embodiments, the probe apparatus for inspecting devices formed on the wafer W has been described. However, the substrate holding method and the substrate holding apparatus of the present invention can be applied to any processing apparatus including a stage for vacuum-attracting and holding a substrate.

In the first to the third sequence, the section P_{I} that is the central portion of the wafer W is sucked first. However, it is optional depending on the division of the suction region 61. For example, it is not necessary when the suction region 611 at the central portion of the holding surface 7a is not provided.

In the third sequence, after two sections in the peripheral portion of the wafer W are sucked, two to four sections adjacent thereto are sucked at the same time. However, it is also possible to suck two sections in the peripheral portion of the wafer W and then suck other sections adjacent thereto (i.e., two sections at the same time) sequentially in a clockwise direction or in a counterclockwise direction, for example.

Further, in the third sequence, after the section P_{I} that is the central portion of the wafer W is sucked, two sections in the peripheral portion of the wafer W are sucked. However, when the suction region 61 is divided into a large number of portions, three or more sections in the peripheral portion of the wafer W may be sucked at the same time after the suction of the section P_{I}.

The substrate is not limited to a semiconductor wafer or a resin substrate. For example, the substrate may be a glass substrate used in a flat panel display represented by a liquid crystal display, or an inspection substrate on which a plurality of IC (semiconductor integrated circuit) chips is mounted such as a resin substrate, a glass substrate or the like.

## Claims

1. A substrate holding method for attracting and holding a circular substrate (W) on a stage (7),
wherein the stage (7) has a circular substrate holding surface (7a) on which a bottom surface of the substrate (W) is attracted and held;
the substrate holding surface (7a) is divided into a plurality of regions (61A ∼ 611) by which the substrate (W) is partially sucked, at least a part of the plurality of regions (61A ∼ 611) being arranged along a circumferential direction on the substrate holding surface (7a); and
an entire surface of the substrate (W) is attracted and held on the stage (7) by sequentially repeating a process of allowing a part of the substrate (W) to be sucked by at least one of the plurality of regions (61A ∼ 61I) and then allowing another part of the substrate (W) to be sucked by a region adjacent to said at least one of the plurality of regions (61A ∼ 61I), **characterized in that**:
the substrate (W) is partially and sequentially sucked along the circumferential direction by said at least a part of the plurality of regions (61A ∼ 61I) arranged along the circumferential direction on the substrate holding surface (7a); and
while the substrate (W) is partially and sucked sequentially along the circumferential direction, a sucked portion of the substrate (W) is pressed against at least one of the plurality of the regions (61A ∼ 61I) of the substrate holding surface (7a) corresponding to the sucked portion by a pressing unit (45, 101).

2. The substrate holding method of claim 1, wherein the plurality of regions (61A ∼ 61I) include a central region corresponding to a central portion of the substrate (W) and a plurality of peripheral regions surrounding the central region, and
wherein the method sequentially performs the steps of:
allowing the central portion of the substrate (W) to be sucked by the central region;
allowing a part of the peripheral portion of the substrate (W) to be sucked by one of the plurality of peripheral regions;
allowing another part of the peripheral portion of the substrate (W) to be sucked by one or two peripheral regions adjacent to said one of the plurality of peripheral regions; and
allowing still another part of the peripheral portion of the substrate (W) to be sucked by a peripheral region adjacent to said one or two peripheral regions.

3. The substrate holding method of claim 1, wherein the plurality of regions (61A ∼ 61I) include a central region corresponding to a central portion of the substrate (W) and a plurality of peripheral regions surrounding the central region, and
wherein the method sequentially performs the steps of:
allowing the central portion of the substrate (W) to be sucked by the central region;
allowing the peripheral portion of the substrate (W) to be partially sucked by two of the plurality of peripheral regions;
allowing another part of the peripheral portion of the substrate (W) to be sucked by two or more peripheral regions adjacent to said two of the plurality of peripheral regions; and
allowing still another part of the peripheral portion of the substrate (W) to be sucked by at least two peripheral regions adjacent to said two or more peripheral regions.

4. A substrate holding apparatus comprising:
a stage (7) having a circular substrate holding surface (7a) for attracting and holding a bottom surface of a circular substrate (W); and
a pressing unit (45, 101) configured to press a part of the substrate (W) against a substrate holding surface (7a),
wherein the substrate holding surface (7a) is divided into a plurality of regions (61A ∼ 61I) by which the substrate (W) is partially sucked, at least a part of the plurality of regions (61A ∼ 61I) being arranged along a circumferential direction on the substrate holding surface (7a), **characterized in that**
said at least a part of the plurality of regions (61A-61I) arranged along the circumferential direction on the substrate holding surface (7a) is configured such that the substrate (W) is partially and sequentially sucked along the circumferential direction, and
the pressing unit (45,101) is configured to press a sucked portion of the substrate (W) against at least one of the plurality of regions (61A-61I) of the substrate holding surface (7a) corresponding to the sucked portion while the substrate (W) is partially and sequentially sucked along the circumferential direction.

5. The substrate holding apparatus of claim 4, wherein at least a part of the plurality of regions (61A ∼ 61I) are arranged in a diametrical direction on the substrate holding surface (7a), and
the pressing unit (45, 101) is arranged to press the substrate (W) so that the substrate (W) is partially and sequentially sucked along the diametrical direction by said at least a part of the plurality of regions (61A ∼ 61I) arranged along the diametrical direction.

6. The substrate holding apparatus of claim 4, wherein the pressing unit (45, 101) is a gas ejection unit (45) configured to eject a gas toward a top surface of the sucked portion.

7. The substrate holding apparatus of claim 6, wherein the gas ejection unit (45) has a nozzle (81) for ejecting the gas for all or each of the plurality of regions (61A ∼ 61I) of the stage (7) or for each group of two or more regions.

8. The substrate holding apparatus of claim 7, wherein the gas is a heating gas whose temperature is maintained within a range of ±10°C with respect to a temperature of the stage (7).

9. The substrate holding apparatus of claim 4, wherein the pressing unit (45, 101) has a pressing member (101) configured to press a top surface of the sucked portion against the substrate holding surface (7a) while being in contact with the top surface of the sucked portion.

10. The substrate holding apparatus of claim 9, wherein a portion of the pressing member (101) which is to be brought into contact with the substrate (W) is made of ceramic, synthetic resin or rubber.

11. The substrate holding apparatus of claim 4, further comprising: a leakage detection unit configured to detect intrusion of external air in a state where the substrate (W) is sucked for all or each of the plurality of regions (61A ∼ 61I) or for each group of two or more regions.

12. The substrate holding apparatus of claim 4, wherein the plurality of regions (61A ∼ 61I) include a central region corresponding to a central portion of the substrate (W) and a plurality of peripheral regions surrounding the central region and corresponding to a peripheral portion of the substrate (W), and
the plurality of peripheral regions include two or more peripheral regions having different areas.

13. The substrate holding apparatus of claim 12, wherein the central region includes a plurality of regions divided in a diametrical direction of the substrate holding surface (7a).

14. The substrate holding apparatus of claim 12, wherein the plurality of peripheral regions include a plurality of regions divided in a diametrical direction of the substrate holding surface (7a).

15. A processing apparatus for performing a predetermined processing on a substrate (W), comprising:
the substrate holding apparatus described in claim 4.

16. The processing apparatus of claim 15, wherein the processing apparatus is a probe apparatus (100) for inspecting electrical characteristics of a plurality of devices formed on the substrate (W).

## Patentansprüche

1. Substrathalteverfahren zum Anziehen und Halten eines kreisförmigen Substrats (W) auf einem Tisch (7),
wobei der Tisch (7) eine kreisförmige Substrathalteoberfläche (7a) aufweist, auf der eine Bodenoberfläche des Substrats (W) angezogen und gehalten wird;
die Substrathalteoberfläche (7a) in eine Vielzahl von Bereichen (61A ∼ 61I) geteilt ist, von denen das Substrat (W) teilweise angesaugt wird, wobei mindestens ein Teil der Vielzahl von Bereichen (61A ∼ 61I) entlang einer Umfangsrichtung an der Substrathalteoberfläche (7a) eingerichtet ist; und
eine Gesamtoberfläche des Substrats (W) auf dem Tisch (7) angezogen und gehalten wird, indem ein Prozess nacheinander wiederholt wird, einem Teil des Substrats (W) zu erlauben, von mindestens einem der Vielzahl von Bereichen (61A ∼ 61I) angesaugt zu werden, und dann einem anderen Teil des Substrats (W) zu erlauben, von einem an den mindestens einen der Vielzahl von Bereichen (61A ∼ 61I) angrenzenden Bereich angesaugt zu werden, **dadurch gekennzeichnet, dass**:
das Substrat (W) teilweise und nacheinander entlang der Umfangsrichtung von mindestens einem Teil der Vielzahl von Bereichen (61A ∼ 61I) angesaugt wird, die entlang der Umfangsrichtung auf der Substrathalteoberfläche (7a) eingerichtet sind; und
während das Substrat (W) teilweise und nacheinander entlang der Umfangsrichtung angesaugt wird, ein angesaugter Abschnitt des Substrats (W) durch eine Druckeinheit (45, 101) gegen mindestens einen der Vielzahl von den Bereichen (61A ∼ 61I) der Substrathaltevorrichtung (7a) entsprechend dem angesaugten Abschnitt gedrückt wird.

2. Substrathalteverfahren nach Anspruch 1, wobei die Vielzahl von Bereichen (61A ∼ 61I) einen Mittelbereich entsprechend einem Mittelabschnitt des Substrats (W) und eine Vielzahl von den Mittelbereich umgebenden Randbereichen beinhaltet, und
wobei das Verfahren nacheinander die Schritte durchführt zum:
Erlauben, dass der Mittelabschnitt des Substrats (W) von dem Mittelbereich angesaugt wird;
Erlauben, dass ein Teil des Randabschnitts des Substrats (W) von einem der Vielzahl von Randbereichen angesaugt wird;
Erlauben, dass ein anderer Teil des Randabschnitts des Substrats (W) von einem oder zwei an den einen der Vielzahl von Randbereichen angrenzenden Randbereichen angesaugt wird; und
Erlauben, dass noch ein weiterer Teil des Randabschnitts des Substrats (W) von einem an den einen oder die zwei Randbereiche angrenzenden Randbereich angesaugt wird.

3. Substrathalteverfahren nach Anspruch 1, wobei die Vielzahl von Bereichen (61A ∼ 61I) einen Mittelbereich entsprechend einem Mittelabschnitt des Substrats (W) und eine Vielzahl von den Mittelbereich umgebenden Randbereichen beinhaltet, und
wobei das Verfahren nacheinander die Schritte durchführt zum:
Erlauben, dass der Mittelabschnitt des Substrats (W) von dem Mittelbereich angesaugt wird;
Erlauben, dass der Randabschnitt des Substrats (W) teilweise von zweien der Vielzahl von Randbereichen angesaugt wird;
Erlauben, dass ein weiterer Teil des Randabschnitts des Substrats (W) von zwei oder mehr an den zwei der Vielzahl von Randbereichen angrenzenden Randbereichen angesaugt wird; und
Erlauben, dass ein noch weiterer Teil des Randabschnitts des Substrats (W) von mindestens zwei an den zwei oder mehr Randbereichen angrenzenden Randbereichen angesaugt wird.

4. Substrathalteeinrichtung, umfassend:
einen Tisch (7), der eine kreisförmige Substrathalteoberfläche (7a) zum Anziehen und Halten einer Bodenoberfläche eines kreisförmigen Substrats (W) aufweist; und
eine Druckeinheit (45, 101), die dazu ausgebildet ist, einen Teil des Substrats (W) gegen eine Substrathalteoberfläche (7a) zu drücken,
wobei die Substrathalteoberfläche (7a) in eine Vielzahl von Bereichen (61A ∼ 61I) geteilt ist, von denen das Substrat (W) teilweise angesaugt wird, wobei mindestens ein Teil der Vielzahl von Bereichen (61A ∼ 61I) entlang einer Umfangsrichtung auf der Substrathalteoberfläche (7a) eingerichtet ist, **dadurch gekennzeichnet, dass**
der mindestens eine Teil der Vielzahl von entlang der Umfangsrichtung auf der Substrathalteoberfläche (7a) eingerichteten Bereichen (61A ∼ 61I) so ausgebildet ist, dass das Substrat (W) teilweise und nacheinander entlang der Umfangsrichtung angesaugt wird, und
die Druckeinheit (45, 101) dazu ausgebildet ist, einen angesaugten Abschnitt des Substrats (W) gegen mindestens einen der Vielzahl von Bereichen (61A ∼ 61I) der Substrathalteoberfläche (7a) entsprechend dem angesaugten Abschnitt zu drücken, während das Substrat (W) teilweise und nacheinander entlang der Umfangsrichtung angesaugt wird.

5. Substrathalteeinrichtung nach Anspruch 4, wobei mindestens ein Teil der Vielzahl von Bereichen (61A ∼ 61I) in einer diametralen Richtung auf der Substrathalteoberfläche (7a) eingerichtet ist, und
die Druckeinheit (45, 101) eingerichtet ist, das Substrat (W) so zu drücken, dass das Substrat (W) teilweise und nacheinander entlang der diametralen Richtung von dem mindestens einen Teil der Vielzahl von entlang der diametralen Richtung eingerichteten Bereichen (61A ∼ 61I) angesaugt wird.

6. Substrathalteeinrichtung nach Anspruch 4, wobei die Druckeinheit (45, 101) eine Gasausstoßeinheit (45) ist, die dazu ausgebildet ist, ein Gas zu einer Oberseitenoberfläche des angesaugten Abschnitts auszustoßen.

7. Substrathalteeinrichtung nach Anspruch 6, wobei die Gasausstoßeinheit (45) eine Düse (81) zum Ausstoßen des Gases für alle oder jeden der Vielzahl von Bereichen (61A ∼ 61I) des Tisches (7) oder für jede Gruppe von zwei oder mehr Bereichen aufweist.

8. Substrathalteeinrichtung nach Anspruch 7, wobei das Gas ein Heizgas ist, dessen Temperatur innerhalb einer Spanne von ±10 °C in Bezug auf eine Temperatur des Tisches (7) gehalten wird.

9. Substrathalteeinrichtung nach Anspruch 4, wobei die Druckeinheit (45, 101) ein Druckbauteil (101) aufweist, das dazu ausgebildet ist, eine Oberseitenoberfläche des angesaugten Abschnitts gegen die Substrathalteoberfläche (7a) zu drücken, während sie in Kontakt mit der Oberseitenoberfläche des angesaugten Abschnitts ist.

10. Substrathalteeinrichtung nach Anspruch 9, wobei ein Abschnitt des Druckbauteils (101), das mit dem Substrat (W) in Kontakt gebracht wird, aus Keramik, Kunstharz oder Kautschuk hergestellt ist.

11. Substrathalteeinrichtung nach Anspruch 4, weiter umfassend: eine Leckdetektionseinheit, die dazu ausgebildet ist, Eindringen von Außenluft in einem Zustand, wo das Substrat (W) für alle oder jedes der Vielzahl von Bereichen (61A ∼ 61I) oder für jede Gruppe von zwei oder mehreren Bereichen angesaugt wird, zu detektieren.

12. Substrathalteeinrichtung nach Anspruch 4, wobei die Vielzahl von Bereichen (61A ∼ 61I) einen Mittelbereich entsprechend einem Mittelabschnitt des Substrats (W) und eine Vielzahl von Randbereichen beinhaltet, die den Mittelbereich umgeben und einem Randabschnitt des Substrats (W) entsprechen, und
die Vielzahl von Randbereichen zwei oder mehr Randbereiche beinhaltet, die unterschiedliche Bereiche aufweisen.

13. Substrathalteeinrichtung nach Anspruch 12, wobei der Mittelbereich eine Vielzahl von Bereichen beinhaltet, die in einer diametralen Richtung der Substrathalteoberfläche (7a) geteilt sind.

14. Substrathalteeinrichtung nach Anspruch 12, wobei die Vielzahl von Randbereichen eine Vielzahl von Bereichen beinhaltet, die in einer diametralen Richtung der Substrathalteoberfläche (7a) geteilt sind.

15. Verarbeitungseinrichtung zum Durchführen einer vorgegebenen Verarbeitung an einem Substrat (W), umfassend:
die Substrathalteeinrichtung, wie sie in Anspruch 4 beschrieben wird.

16. Verarbeitungseinrichtung nach Anspruch 15, wobei die Verarbeitungseinrichtung eine Sondeneinrichtung (100) zum Inspizieren elektrischer Eigenschaften einer Vielzahl von Vorrichtungen ist, die auf dem Substrat (W) gebildet sind.

## Revendications

1. Procédé de maintien de substrat pour attirer et maintenir un substrat circulaire (W) sur un plateau (7),
dans lequel le plateau (7) présente une surface de maintien (7a) de substrat circulaire sur laquelle une surface inférieure du substrat (W) est attirée et maintenue ;
la surface de maintien (7a) de substrat est divisée en une pluralité de régions (61A ∼ 61I) par lesquelles le substrat (W) est partiellement aspiré, au moins une partie de la pluralité de régions (61A ∼ 61I) étant agencées le long d'une direction circonférentielle sur la surface de maintien (7a) de substrat ; et
une surface entière du substrat (W) est attirée et maintenue sur le plateau (7) par répétition séquentielle d'un processus consistant à permettre à une partie du substrat (W) d'être aspirée par au moins une de la pluralité de régions (61A ∼ 61I) et ensuite à permettre à une autre partie du substrat (W) d'être aspirée par une région adjacente à ladite au moins une de la pluralité de régions (61A ∼ 61I), **caractérisé en ce que** :
le substrat (W) est partiellement et séquentiellement aspiré le long de la direction circonférentielle par ladite au moins une partie de la pluralité de régions (61A ∼ 61I) agencées le long de la direction circonférentielle sur la surface de maintien (7a) de substrat ; et
tandis que le substrat (W) est aspiré partiellement et séquentiellement le long de la direction circonférentielle, une portion aspirée du substrat (W) est pressée contre au moins une de la pluralité des régions (61A ∼ 61I) de la surface de maintien (7a) de substrat correspondant à la portion aspirée par une unité de pression (45, 101).

2. Procédé de maintien de substrat selon la revendication 1, dans lequel la pluralité de régions (61A ∼ 61I) incluent une région centrale correspondant à une portion centrale du substrat (W) et une pluralité de régions périphériques entourant la région centrale, et
dans lequel le procédé effectue séquentiellement les étapes consistant à :
permettre à la portion centrale du substrat (W) d'être aspirée par la région centrale ;
permettre à une partie de la portion périphérique du substrat (W) d'être aspirée par l'une de la pluralité de régions périphériques ;
permettre à une autre partie de la portion périphérique du substrat (W) d'être aspirée par une ou deux régions périphériques adjacentes à ladite une de la pluralité de régions périphériques ; et
permettre à encore une autre partie de la portion périphérique du substrat (W) d'être aspirée par une région périphérique adjacente auxdites une ou deux régions périphériques.

3. Procédé de maintien de substrat selon la revendication 1, dans lequel la pluralité de régions (61A ∼ 61I) incluent une région centrale correspondant à une portion centrale du substrat (W) et une pluralité de régions périphériques entourant la région centrale, et
dans lequel le procédé effectue séquentiellement les étapes consistant à :
permettre à la portion centrale du substrat (W) d'être aspirée par la région centrale ;
permettre à la portion périphérique du substrat (W) d'être partiellement aspirée par deux de la pluralité de régions périphériques ;
permettre à une autre partie de la portion périphérique du substrat (W) d'être aspirée par deux régions périphériques ou plus adjacentes auxdites deux de la pluralité de régions périphériques ; et
permettre à encore une autre partie de la portion périphérique du substrat (W) d'être aspirée par au moins deux régions périphériques adjacentes auxdites deux régions périphériques ou plus.

4. Appareil de maintien de substrat comprenant :
un plateau (7) présentant une surface de maintien (7a) de substrat circulaire pour attirer et maintenir une surface inférieure d'un substrat circulaire (W) ; et
une unité de pression (45, 101) configurée pour presser une partie du substrat (W) contre une surface de maintien (7a) de substrat,
dans lequel la surface de maintien (7a) de substrat est divisée en une pluralité de régions (61A ∼ 61I) par lesquelles le substrat (W) est partiellement aspiré, au moins une partie de la pluralité de régions (61A ∼ 61I) étant agencées le long d'une direction circonférentielle sur la surface de maintien (7a) de substrat, **caractérisé en ce que**
ladite au moins une partie de la pluralité de régions (61A-61I) agencées le long de la direction circonférentielle sur la surface de maintien (7a) de substrat est configurée de telle manière que le substrat (W) est partiellement et séquentiellement aspiré le long de la direction circonférentielle, et
l'unité de pression (45, 101) est configurée pour presser une portion aspirée du substrat (W) contre au moins une de la pluralité de régions (61A-61I) de la surface de maintien (7a) de substrat correspondant à la portion aspirée tandis que le substrat (W) est partiellement et séquentiellement aspiré le long de la direction circonférentielle.

5. Appareil de maintien de substrat selon la revendication 4, dans lequel au moins une partie de la pluralité de régions (61A ∼ 61I) sont agencées dans une direction diamétrale sur la surface de maintien (7a) de substrat, et
l'unité de pression (45, 101) est agencée pour presser le substrat (W) de sorte que le substrat (W) soit partiellement et séquentiellement aspiré le long de la direction diamétrale par ladite au moins une partie de la pluralité de régions (61A ∼ 61I) agencées le long de la direction diamétrale.

6. Appareil de maintien de substrat selon la revendication 4, dans lequel l'unité de pression (45, 101) est une unité d'éjection de gaz (45) configurée pour éjecter un gaz vers une surface supérieure de la portion aspirée.

7. Appareil de maintien de substrat selon la revendication 6, dans lequel l'unité d'éjection de gaz (45) présente une buse (81) pour éjecter le gaz pour toutes ou chacune de la pluralité de régions (61A ∼ 61I) du plateau (7) ou pour chaque groupe de deux régions ou plus.

8. Appareil de maintien de substrat selon la revendication 7, dans lequel le gaz est un gaz de chauffage dont la température est maintenue à l'intérieur d'une plage de ±10 °C par rapport à une température du plateau (7).

9. Appareil de maintien de substrat selon la revendication 4, dans lequel l'unité de pression (45, 101) présente un élément de pression (101) configuré pour presser une surface supérieure de la portion aspirée contre la surface de maintien (7a) de substrat tandis qu'elle est en contact avec la surface supérieure de la portion aspirée.

10. Appareil de maintien de substrat selon la revendication 9, dans lequel une portion de l'élément de pression (101) qui doit être amenée en contact avec le substrat (W) est faite de céramique, d'une résine synthétique ou de caoutchouc.

11. Appareil de maintien de substrat selon la revendication 4, comprenant en outre : une unité de détection de fuite configurée pour détecter une intrusion d'air externe dans un état où le substrat (W) est aspiré pour toutes ou chacune de la pluralité de régions (61A ∼ 61I) ou pour chaque groupe de deux régions ou plus.

12. Appareil de maintien de substrat selon la revendication 4, dans lequel la pluralité de régions (61A ∼ 61I) incluent une région centrale correspondant à une portion centrale du substrat (W) et une pluralité de régions périphériques entourant la région centrale et correspondant à une portion périphérique du substrat (W), et
la pluralité de régions périphériques incluent deux régions périphériques ou plus présentant différentes aires.

13. Appareil de maintien de substrat selon la revendication 12, dans lequel la région centrale inclut une pluralité de régions divisées dans une direction diamétrale de la surface de maintien (7a) de substrat.

14. Appareil de maintien de substrat selon la revendication 12, dans lequel la pluralité de régions périphériques incluent une pluralité de régions divisées dans une direction diamétrale de la surface de maintien (7a) de substrat.

15. Appareil de traitement pour effectuer un traitement prédéterminé sur un substrat (W), comprenant :
l'appareil de maintien de substrat selon la revendication 4.

16. Appareil de traitement selon la revendication 15, dans lequel l'appareil de traitement est un appareil de sonde (100) pour inspecter des caractéristiques électriques d'une pluralité de dispositifs formés sur le substrat (W).
